# EUROPEAN PATENT APPLICATION

(11) **EP 4 848 936 A1**
(43) Date of publication of application: **02.12.2026**
(21) Application number: 26156133.6
(22) Date of filing: 03.02.2026
(51) Int. Cl.: H10D 30/66, H10D 62/832, H10D 62/60, H10D 62/17, H10D 62/10, H10D 30/01

(54) **SEMICONDUCTOR DEVICE HAVING LOW ON-RESISTANCE**

(30) Priority: 28.05.2025 KR 20250069895
(71) Applicant: Samsung Electronics Co., Ltd., Suwon-si, Gyeonggi-do 16677 (KR)
(72) Inventor: CHOI, Minwook, Suwon-si (KR); KIM, Taehun, Suwon-si (KR); PARK, Jongwon, Suwon-si (KR); OH, Sewoong, Suwon-si (KR); WOO, Sangsu, Suwon-si (KR); CHUNG, Yonghyuk, Suwon-si (KR); JEONG, Jeehun, Suwon-si (KR); HONG, Sungtaek, Suwon-si (KR)
(74) Representative: Marks & Clerk LLP

(57) **Abstract**

A SiC semiconductor device includes a first conductivity type semiconductor layer (131), second conductivity type doped well regions (133) positioned in the first conductivity type semiconductor layer and spaced apart from each other in a first direction. Gate structures (153) are positioned in the first conductivity type semiconductor layer and includes a gate electrode (150) positioned between the second conductivity type doped well regions and a gate insulating layer (151) positioned between the first conductivity type semiconductor layer and the gate electrode. A portion of a doping pillar (210) is positioned between the gate structures below the second conductivity type doped well region within the first conductivity type semiconductor layer. The doping pillar includes different dopants of the same conductivity type. For example, nitrogen and phosphorous, or boron and aluminium. A source electrode (170) and a drain electrode (180) are positioned spaced apart from each other with the gate structures interposed therebetween.

## Description

### BACKGROUND OF THE INVENTION

The present disclosure relates to a semiconductor device.

In modern society, semiconductor devices are closely related to daily life. In particular, the importance of power semiconductor devices used in various fields such as transportation including electric vehicles, railways, and electric trams, renewable energy systems such as solar power generation and wind power generation, and mobile devices is gradually increasing. A power semiconductor device is a semiconductor device used to handle high voltages or high currents, and performs functions such as power conversion and control in large-scale power systems or high-power electronic devices. A power semiconductor device may have the capability and durability to handle high power, may be capable of handling large amounts of current, and may withstand high voltages. For example, a power semiconductor device may handle voltages ranging from several hundred volts to several thousand volts, and may handle currents ranging from several tens of amperes to several thousand amperes. The power semiconductor device may improve the efficiency of electrical energy by minimizing power loss. In addition, a power semiconductor device may operate stably even in environments such as high temperatures.

Such power semiconductor devices may be classified according to material, and, for example, there are SiC (silicon carbide) power semiconductor devices and GaN (gallium nitride) power semiconductor devices. By manufacturing a power semiconductor device utilizing SiC or GaN instead of a conventional silicon wafer (Si wafer), it may be possible to compensate for (or overcome) the disadvantages of silicon having unstable characteristics at high temperatures. The SiC power semiconductor device is resistant to high temperatures, has low power loss, and may be suitable for electric vehicles, renewable energy systems, and the like. The GaN power semiconductor device may offer high-speed performance, though it requires high manufacturing cost. For example, the GaN power semiconductor device may be suitable for high-speed charging of mobile devices.

### SUMMARY OF THE INVENTION

One aspect of the present disclosure may provide a semiconductor device capable of reducing surface damage during ion implantation while lowering on-resistance, and securing long-term reliability.

An embodiment of the present disclosure provides a semiconductor device including a first conductivity type semiconductor layer, second conductivity type doped well regions positioned on the first conductivity type semiconductor layer and spaced apart from each other in a first direction, gate structures positioned in the first conductivity type semiconductor layer and including a gate electrode positioned between adjacent well regions of the second conductivity type doped well regions and a gate insulating layer positioned between the first conductivity type semiconductor layer and the gate electrode, a doping pillar positioned below the second conductivity type doped well regions and within the first conductivity type semiconductor layer, and a source electrode and a drain electrode positioned spaced apart from each other with one of the gate structures interposed therebetween. A portion of the doping pillar is positioned between two of the gate structures in a plan view, and the doping pillar includes first dopants and second dopants that are different dopants from each other.

Another embodiment of the present disclosure provides a semiconductor device including a first conductivity type semiconductor layer, second conductivity type doped well regions positioned in the first conductivity type semiconductor layer and spaced apart from each other in a first direction, gate structures positioned on the first conductivity type semiconductor layer and including a gate electrode positioned between adjacent well regions of the second conductivity type doped well regions and a gate insulating layer positioned between the first conductivity type semiconductor layer and the gate electrode, and a doping pillar extending in a second direction that is different from the first direction. The doping pillar is positioned below the second conductivity type doped well regions and within the first conductivity type semiconductor layer. A portion of the doping pillar is positioned between two of the gate structures. The semiconductor device further includes a source electrode and a drain electrode positioned spaced apart from each other with one of the gate structures interposed therebetween, wherein, in a cross-section view along the first direction and the second direction, a side surface of the doping pillar has convex portions protruding toward the first conductivity type semiconductor layer and concave portions indented with respect to the first conductivity type semiconductor layer along the second direction.

Another embodiment of the present disclosure provides a semiconductor device including a first conductivity type semiconductor layer, second conductivity type doped well regions positioned in the first conductivity type semiconductor layer and spaced apart from each other in a horizontal direction, gate structures positioned on the first conductivity type semiconductor layer and including a gate electrode positioned between adjacent will regions of the second conductivity type doped well regions and a gate insulating layer positioned between the first conductivity type semiconductor layer and the gate electrode, below the second conductivity type doped well regions within the first conductivity type semiconductor layer, and including different dopants of the same conductivity type, second doping pillars positioned below the second conductivity type doped well regions within the first conductivity type semiconductor layer, and having a different conductivity type from the first doping pillars, and a source electrode and a drain electrode spaced apart from each other with the gate structures interposed therebetween. A portion of each of the first doping pillars is positioned between adjacent gate structures of the gate structures. Within the first conductivity type semiconductor layer, the first doping pillars and the second doping pillars are alternatively arranged in the horizontal direction.

Another embodiment of the present disclosure provides a method of manufacturing a semiconductor device including forming a first conductivity type semiconductor layer on a substrate, forming a first doping pillar in the first conductivity type semiconductor layer by ion implantation of dopants multiple times, while changing a doping projected range (Rp), doping range straggle (ΔRp), or both, forming second conductivity type doped well regions on the first doping pillar of the first conductivity type semiconductor layer, etching the first conductivity type semiconductor layer from an upper surface of the first conductivity type semiconductor layer to below a lower surface of the second conductivity type doped well regions to form a gate trench, forming a gate structure by forming a gate insulating layer in the gate trench and forming a gate electrode on the gate insulating layer, and forming a source electrode and a drain electrode spaced apart from each other with the gate structure interposed therebetween.

Forming the first doping pillar may include forming the first doping pillar by performing ion implantation multiple times using different dopants.

Forming the first doping pillar may include forming a first pillar region with a first dopant having a relatively greater doping projected range (Rp), and forming a second pillar region with a second dopant having a relatively greater doping range straggle (ΔRp).

The method of manufacturing the semiconductor device may include further forming second doping pillars spaced apart from each other in the first direction in a first conductivity type semiconductor layer.

The first doping pillar may be formed between the second doping pillars.

The method of manufacturing the semiconductor device may further include performing ion implantation into the second conductivity type doped well region to form a first conductivity type doped layer, and performing ion implantation into the second conductivity type doped well region to form a second conductivity type doped layer.

Forming the gate trench may include etching the first conductivity type semiconductor layer such that the first conductivity type doped layer is positioned adjacent to the gate trench.

Forming the gate trench may include forming such that a lower surface of the gate trench is in contact with the first conductivity type semiconductor layer, a lower surface of the gate trench is in contact with the first doping pillar, a lower surface of the gate trench is in contact with the second doping pillar, a side surface of the gate trench is in contact with the second conductivity type doped well region, and a side surface of the gate trench is in contact with the first conductivity type doped layer.

The method of manufacturing the semiconductor device may include forming an interlayer insulating layer on the gate structure so as to cover the gate structure, patterning the interlayer insulating layer to expose the second conductivity type doped layer between the gate structures, and forming the source electrode on the interlayer insulating layer to be connected to the second conductivity type doped layer.

Another embodiment of the present disclosure provides a power semiconductor device including: a first conductivity type semiconductor layer formed of a compound semiconductor material, the first conductivity type semiconductor layer having a first surface and a second surface facing away from each other; a source electrode disposed on the first surface of the first conductivity type semiconductor layer; a drain electrode disposed on the second surface of the first conductivity type semiconductor layer, the drain electrode is electrically connected to the first conductivity type semiconductor layer; first conductivity type source regions formed in the first conductivity type semiconductor layer and electrically connected to the source electrode; second conductivity type doped well regions positioned in the first conductivity type semiconductor layer, the second conductivity type doped well regions being in contact with the first conductivity type source regions; and gate electrodes positioned between the second conductivity type doped well regions. The gate electrodes are configured to control current flow between the source electrode and the drain electrode and in a direction extending from the first surface of the first conductivity type semiconductor layer to the second surface of the first conductivity type semiconductor layer. The power semiconductor device further includes a gate insulating layer positioned between the gate electrodes and the second conductivity type doped well regions; and a first set of doped regions formed in the first conductivity type semiconductor layer. Each doped region of the first set of doped regions has the same conductivity type, the doped regions of the first set of doped regions are in contact with one another, a first charge carrier dopant concentration curve of the first set of doped regions along a first line extending from the source electrode to the drain electrode has a first peak concentration and a second peak concentration, the first charge carrier dopant concentration curve corresponds to that of whichever is greater between p-type carriers and n-type carriers in each doped region of the first set of doped regions, a dominant atomic element at the first peak concentration is different from that at the second peak concentration, and in a plan view, a portion of the first set of doped regions is disposed between adjacent two of the gate electrodes.

The semiconductor device according to embodiments may have reduced surface damage that may be induced during ion implantation while providing low on-resistance and securing long-term reliability.

At least some of the above and other features of the invention are set out in the claims.

### BRIEF DESCRIPTION OF THE DRAWINGS

FIG. 1 is a plan view showing a semiconductor device according to an embodiment.
FIG. 2 is a cross-sectional view taken along line A-A' of FIG. 1.
FIG. 3 is a cross-sectional view showing a semiconductor device according to another embodiment, and corresponding to FIG. 2 (for example, FIG. 3 is a cross-sectional view taken along a line equivalent to the line A-A' of FIG. 1 used for the cross-sectional view of FIG. 2).
FIG. 4 is a cross-sectional view showing a semiconductor device according to another embodiment, and corresponding to FIG. 2.
FIG. 5 is a cross-sectional view showing a semiconductor device according to another embodiment, and corresponding to FIG. 2.
FIG. 6 is a cross-sectional view showing a semiconductor device according to an embodiment, and corresponding to FIG. 2.
FIG. 7 is a cross-sectional view showing a semiconductor device according to another embodiment, and corresponding to FIG. 2.
FIG. 8 is a cross-sectional view showing a semiconductor device according to another embodiment, and corresponding to FIG. 2.
FIG. 9 is a cross-sectional view showing a semiconductor device according to another embodiment, and corresponding to FIG. 2.
FIGS. 10 to 18 are cross-sectional views showing a method of manufacturing a semiconductor device in process order (or sequence).
FIGS. 19 and 20 are graphs each illustrating a charge carrier dopant distribution.
FIG. 21 is another plan view showing the semiconductor device according to the embodiment illustrated in FIGS. 1 and 2.

### DETAILED DESCRIPTION OF THE EMBODIMENTS

Hereinafter, various embodiments of the present disclosure will be described in detail with reference to the attached (or accompanying) drawings so that a person having ordinary skill in the art to which the present disclosure pertains can easily implement the present invention. The present disclosure may be embodied in many different forms and is not limited to the embodiments set forth herein.

The drawings and description are to be regarded as illustrative in nature and not restrictive. Like reference numerals designate like elements throughout the specification.

The size and thickness of each constituent element as shown in the drawings are randomly indicated (or may be arbitrarily illustrated) for better understanding and ease of description, and this disclosure is not necessarily limited to as shown. In the drawings, the thickness of layers, regions, etc., may be exaggerated for clarity. In addition, in the drawings, for better understanding and ease of description, the thickness of some layers and areas is exaggerated.

The word "on" or "above" may mean being disposed on or below the object portion, and does not necessarily mean being disposed on the upper side of the object portion based on a gravitational direction. In addition, it will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

In addition, unless explicitly described to the contrary, the word "comprise," and variations such as "comprises" or "comprising," will be understood to imply the inclusion of stated elements but not the exclusion of any other elements. In addition, throughout the specification, when a component is described as "including" a particular element or group of elements, it is to be understood that the component is formed of only the element or the group of elements, or the element or group of elements may be combined with additional elements to form the component, unless the context indicates otherwise. The term "consisting of," on the other hand, indicates that a component is formed only of the element(s) listed.

In addition, in this specification, unless context indicates otherwise, the phrase "on a plane" or "in a plan view" means viewing a target portion from the top, and the phrase "on a cross-section" or "in a cross-sectional view" means viewing a cross-section formed by vertically cutting a target portion from the side.

Items described in the singular herein may be provided in plural, as can be seen, for example, in the drawings. Thus, the description of a single item that is provided in plural should be understood to be applicable to the remaining plurality of items unless context indicates otherwise.

Ordinal numbers such as "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first" in a particular claim) may be described elsewhere with a different ordinal number (e.g., "second" in the specification or another claim).

Terms such as "same," "equal," "constant," "flat," etc. as used herein, are intended to encompass meanings that include typical variations resulting from conventional manufacturing processes and/or accommodate tolerances acceptable in the manufacturing process of the semiconductor device, unless the context or other statements indicate otherwise. For example, 'same' and 'equal' may encompass identicality or near identicality. The term "substantially" may be used herein to emphasize this meaning.

In addition, throughout the specification, two directions parallel to the upper surface of the substrate and perpendicular to each other may be respectively described as a first direction D1 and a second direction D2, and a direction perpendicular to the upper surface of the substrate may be described as a third direction D3. For example, the first direction D1 and the second direction D2 may be the length direction and the width direction, respectively, and the third direction D3 may be the thickness direction (or depth direction). It will be understood that these are example directions, expressed relative to a device, and do not imply any particular orientation of that device.

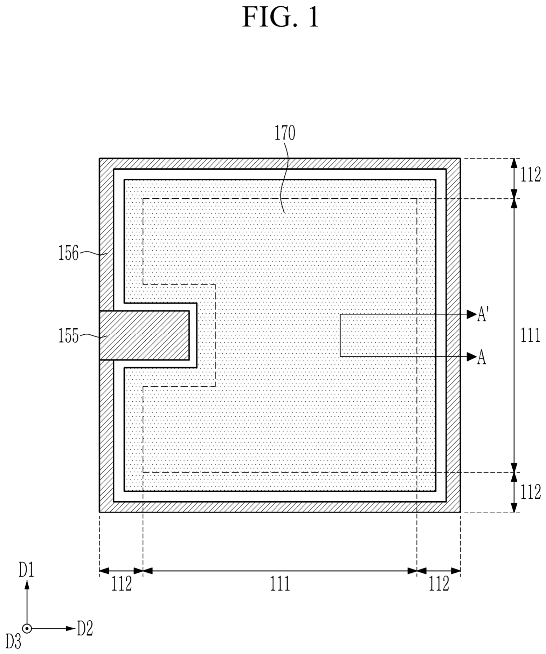

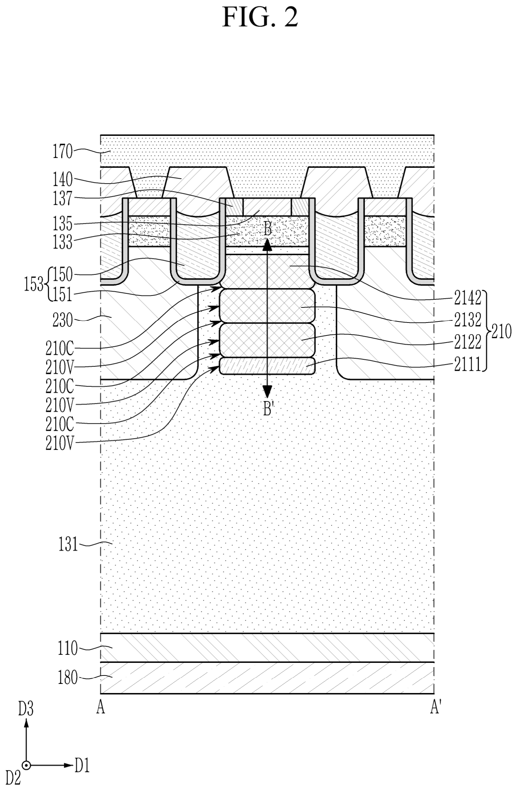

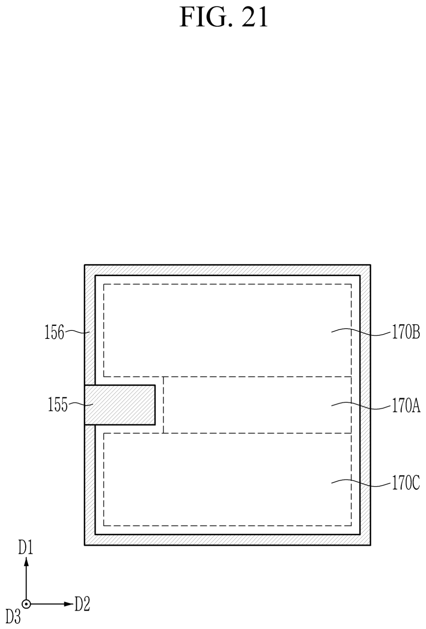

FIG. 1 is a plan view showing a semiconductor device according to an embodiment. FIG. 2 is a cross-sectional view taken along line A-A' of FIG. 1. FIG. 21 is another plan view showing the semiconductor device illustrated in FIGS. 1 and 2.

For clear understanding and simplified illustration, FIG. 1 mainly illustrates a source electrode 170, a gate pad 155, and a gate wiring 156, while other components (or elements) are omitted.

Referring to FIG. 1 and FIG. 2, the semiconductor device may include a substrate 110, a first conductivity type semiconductor layer 131 positioned on an upper surface of the substrate 110, second conductivity type doped well regions 133 positioned in the first conductivity type semiconductor layer 131, gate structures 153 including a gate electrode 150 and a gate insulating layer 151 positioned in (or on) the first conductivity type semiconductor layer 131, a first doping pillar 210 positioned in the first conductivity type semiconductor layer, a source electrode 170 positioned on the second conductivity type doped well regions 133, and a drain electrode 180 positioned below a lower surface of the substrate 110.

The substrate 110 (or the semiconductor device) may include a cell region 111 and a peripheral region 112 surrounding the cell region 111.

The source electrode 170 may be positioned on the cell region 111 of the substrate 110. The source electrode 170 may cover the cell region 111 of the substrate 110. For example, the cell region 111 of the substrate 110 may be entirely overlapped with the source electrode 170 in the third direction D3.

The gate pad 155 may be positioned on the peripheral region 112 of the substrate 110. The gate pad 155 may be positioned on one side of the source electrode 170 in the first direction D1 or the second direction D2. The gate pad 155 may be spaced apart from the source electrode 170 in the first direction D1 or the second direction D2. The gate pad 155 and the source electrode 170 may not be directly connected to each other.

For example, on a plane extending in the first direction D1 and the second direction D2 (such as illustrated in FIG. 1), the size (width or length) of the gate pad 155 may be smaller than the size of the source electrode 170 in the first direction D1 and the second direction D2. The gate pad 155 may be positioned close to (or adjacent to) one side of the source electrode 170. The gate pad 155 may be positioned at approximately (or adjacent to) the middle of one side of the source electrode 170. In a plan view, the gate pad 155 may have four sides (or edges), and three of them (sides of the gate pad 155 other than the one side) may be surrounded by the source electrode 170. For example, in the plan view, the gate pad 155 may be surrounded by the source electrode 170 such that three of the four edges of the gate pad 155 face the source electrode 170. The source electrode 170 has an overall rectangular shape, the source electrode 170 has a concave portion curved inward on one side in a plan view, and the gate pad 155 may be positioned within the concave portion of the source electrode 170 such that at least a portion of the gate pad 155 may be inserted into the source electrode 170.

For example, referring to FIG. 21, the source electrode 170 may have a first portion 170A, a second portion 170B and a third portion 170C. The first portion 170A may be positioned adjacent to a first side (or edge) of the gate pad 155 in the second direction D2, and have a larger area than the gate pad 155. The second portion 170B may be positioned adjacent to a second side of the gate pad 155 in the first direction D1 and directly adjacent to (or directly connected to) a first side of the first portion 170A in the first direction D1. The second portion 170B may have a length in the second direction D2 greater than that of the first portion 170A. The second portion 170B may have a length in the first direction D1 greater than that of the first portion 170A. The third portion 170C may be positioned adjacent to a third side of the gate pad 155 in the first direction D1 and directly adjacent to (or directly connected to) a second side of the first portion 170A in the second direction D1. The third portion 170C may have a length in the second direction D2 greater than that of the first portion 170A. The third portion 170C may have a length in the first direction D1 greater than that of the first portion 170A.

In some embodiments, the source electrode 170 may have a first portion positioned at one side in the second direction D2 of the gate pad 155 and having a larger area than the gate pad 155, a second portion positioned at one side in the first direction D1 of the gate pad 155 and at one side in the second direction D2 of the first portion, the second portion having a length in the second direction D2 similar to that of the gate pad 155 and a length in the first direction D1 smaller than that of the first portion, and a third portion positioned at the other side in the first direction D1 of the gate pad 155 and at one side in the second direction D2 of the first portion, the third portion having a length in the second direction D2 similar to that of the gate pad 155 and a length in the first direction D1 smaller than that of the first portion.

In some embodiments, a gate wiring 156 may be positioned on the peripheral region 112 of the substrate 110. The gate wiring 156 may be connected to the gate pad 155. The gate wiring 156 may extend along the periphery of the source electrode 170 from the gate pad 155. In some embodiments, the gate wiring 156 may extend to be positioned over (e.g. to span) the entire peripheral region 112. For example, the gate wiring 156 may surround the source electrode 170. As shown in Figure 1, this surrounding may be such that the gate pad 155 and gate wiring 156 in combination completely surround the source electrode 170. The gate wiring 156 may be spaced apart from the source electrode 170 in the first direction D1 and/or the second direction D2. The gate wiring 156 and the source electrode 170 may not be directly connected to each other.

The source electrode 170 may extend downward in the third direction D3 and may be electrically connected to (or in active source contact with) the second conductivity type doped well region 133, which will be described later. In addition, the gate pad 155 and the gate wiring 156 may be electrically connected to the gate electrode 150.

The substrate 110 may be a semiconductor layer having a crystalline structure (e.g., a single-crystalline structure). The substrate 110 may be a semiconductor substrate including SiC (silicon carbide). For example, the substrate 110 may be formed of a 4H SiC substrate. In some cases, the substrate 110 may be formed of a 3C SiC substrate or a 6H SiC substrate. The substrate 110 may be doped by the first conductivity type dopant (or charge carrier impurity). For example, 3C SiC may have a cubic zinc-blende crystal structure. 4H SiC may have a hexagonal crystal structure with a four-layer periodicity. 6H SiC may have a hexagonal crystal structure with a six-layer periodicity. For example, the first conductivity type dopant may be an n-type dopant. For example, the substrate 110 may be doped as (or doped to be) n-type. The substrate 110 may be highly doped with n-type impurities. The resistivity of the substrate 110 may be 0.005 Ω·cm or more and 0.035 Ω·cm or less. The thickness of the substrate 110 may be 10 µm or greater and 700 µm or less. The material, doping type, doping concentration, resistivity, or thickness of the substrate 110 are not limited thereto, and may be variously changed. The substrate 110 may have a first surface and a second surface facing away from each other. The first surface of the substrate 110 may be an upper surface of the substrate 110, and the second surface of the substrate 110 may be a lower surface of the substrate 110.

In semiconductor technology, if a semiconductor contains both p-type and n-type impurities (or charge carrier dopants), the conductivity-type of the semiconductor will be determined by which type of impurity is in greater concentration. Therefore, if a semiconductor has both p-type and n-type impurities, the net conductivity type will be determined by the dominant impurity concentration. As used herein, a semiconductor region of a "first conductivity-type" denotes that the dominant impurities in the semiconductor region is (or are) a first conductivity-type impurity. As used herein, a "doping concentration" refers the net concentration of the impurities in the semiconductor region (e.g., the amount of first conductivity-type impurities minus the amount of second conductivity-type impurities, divided by the volume of the semiconductor region).

The first conductivity type semiconductor layer 131 may be positioned on the first surface (for example, on the upper surface of the substrate 110). A lower surface of the first conductivity type semiconductor layer 131 may be in contact with the upper surface of the substrate 110. However, this is not limited thereto, and another layer may be further positioned between the substrate 110 and the first conductivity type semiconductor layer 131. The first conductivity type semiconductor layer 131 may be an epitaxy layer formed by an epitaxial growth method using the substrate 110 as a seed layer.

The first conductivity type semiconductor layer 131 may be formed of a compound semiconductor material. In some embodiments, the compound semiconductor material may be, for example, a III-V, II-VI, or IV-IV compound semiconductor. For example, the compound semiconductor layer may include a III-V semiconductor layer such as GaN, GaAs, or InP, a II-VI semiconductor layer such as ZnO or CdTe or a IV-IV semiconductor layer such as SiC or SiGe.

In an embodiment of the present invention, the first conductivity type semiconductor layer 131 may include SiC. For example, the first conductivity type semiconductor layer 131 may include 4H SiC. The first conductivity type semiconductor layer 131 may be doped as n-type. The first conductivity type semiconductor layer 131 may be doped with a low concentration in an n-type. For example, the first conductivity type semiconductor layer 131 may be a SiC layer doped to be n-type, and the doping concentration of the first conductivity type semiconductor layer 131 may be lower than that of the substrate 110. The doping concentration of the first conductivity type semiconductor layer 131 may be lower than the doping concentration of the substrate 110. The doping concentration of the first conductivity type semiconductor layer 131 may be 1×10¹⁵ cm⁻³ or more and 1×10¹⁷ cm⁻³ or less. The thickness of the first conductivity type semiconductor layer 131 may be 1 µm or more and 13 µm or less. The material, doping type, or doping concentration of the first conductivity type semiconductor layer 131 is not limited thereto and may be variously changed.

The second conductivity type doped well region 133 may be positioned in the first conductivity type semiconductor layer 131. The second conductivity type doped well region 133 may be positioned within the first conductivity type semiconductor layer 131. The first conductivity type semiconductor layer 131 may have main surfaces including an upper surface and a lower surface. The upper surface and the lower surface may face away from each other. The second conductivity type doped well region 133 may be positioned adjacent to the upper surface of the first conductivity type semiconductor layer 131. In some embodiments, the upper surface of the second conductivity type doped well region 133 and the upper surface of the first conductivity type semiconductor layer 131 may have the same level in the third direction D3 (or the same height level). For example, the upper surface of the second conductivity type doped well region 133 and the upper surface of the first conductivity type semiconductor layer 131 may be coplanar. The first conductivity type semiconductor layer 131 may surround the lower surface and the side surfaces of the second conductivity type doped well region 133.

The substrate 110 and the first conductivity type semiconductor layer 131 may be a continuous structure formed of the same material (e.g., SiC) without a clear boundary interface therebetween, though the substrate 110 and the first conductivity type semiconductor layer 131 may have different doping concentrations from each other. The substrate 110 and the first conductivity type semiconductor layer 131 may have the same crystalline structure (e.g., one of 4H SiC, 3C SiC and 6H SiC) as each other.

The second conductivity type doped well region 133 may be formed as a part of the first conductivity type epitaxial layer (or first conductivity type semiconductor layer) 131. The second conductivity type doped well region 133 may be provided with the first conductivity type semiconductor layer 131. For example, charge carrier dopants may be introduced into the first conductivity type semiconductor layer 131 to form the second conductivity type doped well region 133, which is not materially distinctive from the first conductivity type epitaxial layer (or first conductivity type semiconductor layer) 131. Reference to an element being provided with another element may be referred to with the intention of encompassing these alternatives.

The second conductivity type doped well regions 133 may be spaced apart from each other in the first direction D1. The gate structure 153 may be positioned between the second conductivity type doped well regions 133. A side surface in (or facing toward) the first direction D1 of the second conductivity type doped well region 133 may be in contact with a side surface in the first direction D1 of the gate structure 153.

The second conductivity type doped well region 133 may extend from the upper surface of the first conductivity type semiconductor layer 131 toward the lower surface of the first conductivity type semiconductor layer 131. In some embodiments, the second conductivity type doped well region 133 may extend from the upper surface of the first conductivity type semiconductor layer 131 to a certain depth in the third direction D3. The second conductivity type doped well region 133 may be formed in at least a portion of the first conductivity type semiconductor layer 131 by an ion implantation method.

The second conductivity type doped well region 133 may include SiC. In some embodiments, the second conductivity type doped well region 133 may include 4H SiC. The second conductivity type doped well region 133 may be doped to be p-type. The second conductivity type doped well region 133 may be doped with low concentration as p-type. The doping concentration of the second conductivity type doped well region 133 may be 1×10¹⁷ cm⁻³ or more and 1×10¹⁹ cm⁻³ or less. The material, doping type, and doping concentration of the second conductivity type doped well region 133 are not limited thereto and may be variously changed.

The semiconductor device may further include a second conductivity type doped layer (or well contact region) 135 and a first conductivity type doped layer (or source region) 137 positioned on the first conductivity type semiconductor layer 131.

The second conductivity type doped layer 135 may be provided with (e.g., be positioned in) the first conductivity type semiconductor layer 131. The second conductivity type doped layer 135 may be positioned within the first conductivity type semiconductor layer 131. The second conductivity type doped layer 135 may be positioned within (e.g., provided with) the second conductivity type doped well region 133. The second conductivity type doped layer 135 may be positioned adjacent to the upper surface of the second conductivity type doped well region 133. In some embodiments, the upper surface of the second conductivity type doped layer 135 and the upper surface of the second conductivity type doped well region 133 may have the same level in the third direction D3. For example, the upper surface of the second conductivity type doped layer 135 and the upper surface of the second conductivity type doped well region 133 may be coplanar. The second conductivity type doped well region 133 may surround the lower surface and side surface of the second conductivity type doped layer 135.

The second conductivity type doped layer 135 may be connected to the source electrode 170. The second conductivity type doped layer 135 may have a width greater than a width of the source electrode 170. In some embodiments, a silicide layer may be positioned between the second conductivity type doped layer 135 and the source electrode 170.

The second conductivity type doped layer 135 may extend in the third direction D3 from the upper surface of the first conductivity type semiconductor layer 131. In this case, the thickness of the second conductivity type doped layer 135 in the third direction D3 may be smaller than the thickness of the second conductivity type doped well region 133 in the third direction D3. In addition, the second conductivity type doped layer 135 may have a width (or length), for example in the first direction D1 and/or second direction D2, narrower than the second conductivity type doped well region 133. For example, the second conductivity type doped layer 135 may be embedded within the second conductivity type doped well region 133. The second conductivity type doped layer 135 may be formed in at least a portion of the second conductivity type doped well region 133 by an ion implantation method.

The second conductivity type doped layer 135 may include SiC. For example, the second conductivity type doped layer 135 may include 4H SiC. The second conductivity type doped layer 135 may be doped as p-type. The second conductivity type doped layer 135 may form an ohmic contact with the source electrode 170. For example, the second conductivity type doped layer 135 may be heavily doped with p-type. The ohmic contact may be an electrical contact between elements (or components) that exhibits substantially linear current-voltage characteristics, such as a low-resistance, non-rectifying contact permitting bidirectional current flow without a significant potential barrier. In some embodiments, the doping concentration of the second conductivity type doped layer 135 may be higher than the doping concentration of the second conductivity type doped well region 133. The doping concentration of the second conductivity type doped layer 135 may be 1×10¹⁸ cm⁻³ or more and 5×10²⁰ cm⁻³ or less. The material, doping type, or doping concentration of the second conductivity type doped layer 135 are not limited thereto and may be variously changed.

The first conductivity type doped layer 137 may be provided with (e.g., be positioned in) the first conductivity type semiconductor layer 131. The first conductivity type doped layer 137 may be positioned within the first conductivity type semiconductor layer 131. The first conductivity type doped layer 137 may be positioned within (e.g., provided with) the second conductivity type doped well region 133. The first conductivity type doped layer 137 may be positioned adjacent to the upper surface of the second conductivity type doped well region 133. In some embodiments, the upper surface of the first conductivity type doped layer 137 and the upper surface of the second conductivity type doped well region 133 or the upper surface of the second conductivity type doped layer 135 may have the same level in the third direction D3. For example, the upper surface of the first conductivity type doped layer 137 and the upper surface of the second conductivity type doped well region 133 or the upper surface of the second conductivity type doped layer 135 may be coplanar. The second conductivity type doped well region 133 may surround the lower surface and side surface of the first conductivity type doped layer 137.

The first conductivity type doped layer 137 may be positioned adjacent to the gate structure 153. The first conductivity type doped layer 137 may be adjacent to one side surface in the first direction D1 of the gate structure 153. In some embodiments, first conductivity type doped layer 137 may be adjacent to the side surface in the first direction D1 of the gate structure 153. For example, between two gate structures 153 positioned adjacent to each other in the first direction D1, the second conductivity type doped well region 133 is positioned on the central region in the first direction D1 of the second conductivity type doped well region 133 in a plan view, the second conductivity type doped layer 135 is positioned in the regions on both sides (or opposite sides) in the first direction D1, the first conductivity type doped layer 137 may be positioned adjacent to the gate structures 153, respectively. For example, the source region 137 may be positioned on a corresponding one of two opposite sides of the second conductivity type doped layer 135 in the first direction D1, and the source region 137 may be positioned on a corresponding one of two adjacent gate structures 153.

The first doping pillar 210 may be positioned below (in the third direction D3) the second conductivity type doped well region 133 in which the first conductivity type doped layer 137 is positioned. For example, the first conductivity type doped layer 137 may overlap the first doping pillar 210 in the third direction D3. In some embodiments, a second doping pillar 230 (which will be described below) may not be positioned under (in the third direction D3) the second conductivity type doped well region 133, and may not be positioned under the first conductivity type doped layer 137. For example, the first conductivity type doped layer 137 may not overlap the second doping pillar 230 in the third direction D3.

The first conductivity type doped layer 137 may extend downward in the third direction D3 from the upper surface of the first conductivity type semiconductor layer 131. In some embodiments, the thickness of the first conductivity type doped layer 137 in the third direction D3 may be smaller than the thickness of the second conductivity type doped well region 133 in the third direction D3. In addition, the first conductivity type doped layer 137 may have a width (or length), for example in the first direction D1 and/or second direction D2, narrower than the second conductivity type doped well region 133. For example, the first conductivity type doped layer 137 may be embedded within (e.g., provided with) the second conductivity type doped well region 133. The first conductivity type doped layer 137 may be formed on (or in) at least a portion of the second conductivity type doped well region 133 by an ion implantation method.

The first conductivity type doped layer 137 may include SiC. For example, the first conductivity type doped layer 137 may include 4H SiC. The first conductivity type doped layer 137 may be doped as n-type. The first conductivity type doped layer 137 may be highly doped with n-type. The doping concentration of the first conductivity type doped layer 137 may be 1×10¹⁸ cm⁻³ or more and 5×10²⁰ cm⁻³ or less. The material, doping type, or doping concentration of the first conductivity type doped layer 137 is not limited thereto and may be variously changed.

The gate structure 153 may be positioned in (or on) the first conductivity type semiconductor layer 131. At least a portion of the gate structure 153 may be positioned within the first conductivity type semiconductor layer 131. The gate structure 153 may extend in the third direction D3 downward from the upper surface of the first conductivity type semiconductor layer 131 toward the lower surface of the first conductivity type semiconductor layer 131. In some embodiments, the lower surface of the gate structure 153 may be positioned within the first conductivity type semiconductor layer 131, and may not contact the lower surface of the first conductivity type semiconductor layer 131. For example, the gate structure 153 may not extend until it contacts the lower surface of the first conductivity type semiconductor layer 131.

The gate structures 153 may be positioned spaced apart from each other in the first direction D1. The second conductivity type doped well region 133 may be positioned between gate structures 153 spaced apart from each other in the first direction D1. Between gate structures 153 spaced apart from each other in the first direction D1, the first conductivity type doped layer 137 and the second conductivity type doped layer 135 may be positioned. In addition, in a plan view, a portion of the first doping pillar 210 may be positioned between the gate structures 153. The gate structure 153 may be elongated in the second direction D2.

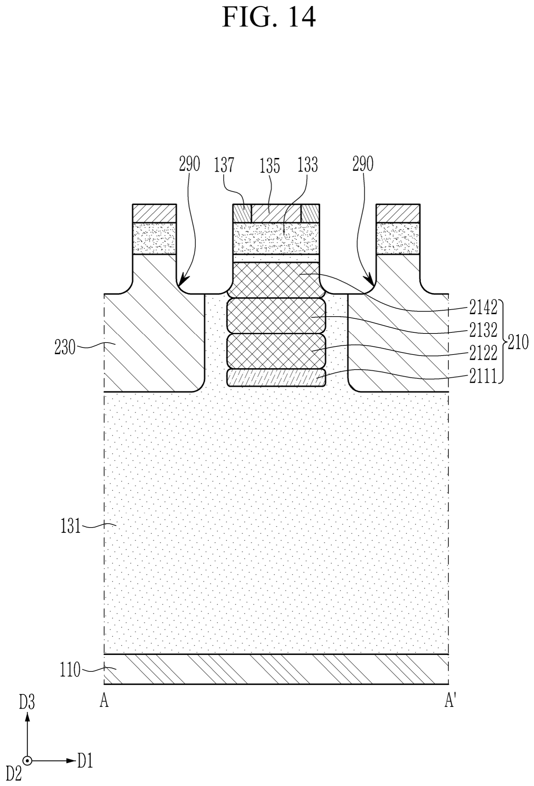

For example, the gate structure 153 may have a trench-type gate structure (or a trench-fill type structure). For example, the first conductivity type semiconductor layer 131 may have a gate trench 290 (shown in FIG. 14) that is recessed to a certain depth below the upper surface in the third direction D3, and at least a portion of the gate electrode 150 may be positioned within the gate trench 290. For example, at least a portion of the gate structure 153 may be embedded within the first conductivity type semiconductor layer 131.

Accordingly, the level in the third direction D3 (or height level) of the lower surface of the gate structure 153 may be lower than the level in the third direction D3 of the upper surface of the first conductivity type semiconductor layer 131. The height level of the lower surface of the gate structure 153 may be positioned higher than the level in the third direction D3 of the lower surface of the first conductivity type semiconductor layer 131, and may be lower than the level in the third direction D3 of the lower surface of the second conductivity type doped well region 133. The term "height level" in the third direction D3 may be described as "higher" when farther from the upper surface of the substrate 110, and may be described as "lower" when closer to the upper surface of the substrate 110. When a height level of a component varies in the first direction D1 or the second direction D2, the height level may be described based on the level of a portion closest to the upper surface of the substrate 110.

In addition, the gate structure 153 may extend downward beyond the lower surface of the second conductivity type doped well region 133, and the lower surface of the gate structure 153 may contact the first conductivity type semiconductor layer 131. At least a portion of the side surface of the gate structure 153 (that extends in the second direction D2) may be in contact with the side surface of the doped well region 133 (that extends in the second direction D2). At least a portion of the side surface (that extends in the second direction D2) of some of the gate structure 153 may be in contact with the side surface (that extends in the second direction D2) of some of the first conductivity type doped layer 137. At least a portion of the side surface (that extends in the second direction D2) of some of the gate structure 153 may be in contact with the side surface (that extends in the second direction D2) of some of the second conductivity type doped layer 135.

In addition, the lower surface of the gate structure 153 may be connected to the first doping pillar 210 and the second doping pillar 230. Accordingly, the lower surface of each of the gate structures 153 may be in contact with the first conductivity type semiconductor layer 131, the first doping pillar 210, and the second doping pillar 230.

In some embodiments, the gate structure 153 may have a planar form gate structure. For example, the gate structure 153 may have a plate shape having a flat upper surface and a flat lower surface, and may be positioned on a flat surface of the first conductivity type semiconductor layer 131. The lower surface of the gate structure 153 may be positioned at a higher height level in the third direction D3 than an uppermost surface of the first conductivity type semiconductor layer 131. The gate structure 153 may overlap the second conductivity type doped well region 133 and the first conductivity type doped layer 137 in the third direction D3.

The gate structure 153 may include a gate insulating layer 151 and a gate electrode 150.

The gate insulating layer 151 may be a thin film having a uniform thickness along the inner surface of the gate trench 290. For example, the gate insulating layer 151 may conformally cover the inner surface of the gate trench 290.

At least a portion of the gate electrode 150 may be positioned within the gate trench 290. The gate electrode 150 may fill the entire (or partial) internal space of the gate trench 290 remaining after the gate insulating layer 151 is occupied. In some embodiments, a remaining portion of the gate electrode 150 may protrude above the upper surface of the first conductivity type semiconductor layer 131, and may be positioned on the first conductivity type semiconductor layer 131.

In a plan view, at least a portion of the gate electrode 150 may be positioned between the second conductivity type doped well regions 133 in the first direction D1. The gate insulating layer 151 may be positioned between the first conductivity type semiconductor layer 131 and the gate electrode 150. The gate insulating layer 151 may be positioned below the third direction D3 of the gate electrode 150, and may cover the lower surface of the gate electrode 150. The gate electrode 150 may be spaced apart from the first conductivity type semiconductor layer 131 by the gate insulating layer 151, and may be insulated from the first conductivity type semiconductor layer 131.

The gate electrode 150 may include a conductive material. For example, the gate electrode 150 may include polysilicon doped with a dopant. As another example, the gate electrode 150 may include a metal, a metal alloy, a conductive metal nitride, a metal silicide, a doped semiconductor material, a conductive metal oxide, a conductive metal oxynitride, or a combination thereof. The gate electrode 150 may be formed as a single layer or a multilayer.

The gate insulating layer 151 may include an insulating material. For example, the gate insulating layer 151 may include SiO₂. However, this is not limited thereto, and the material of the gate insulating layer 151 may be variously changed. As another example, the gate insulating layer 151 may include SiN, SiON, SiC, SiCN, or a combination thereof. The gate insulating layer 151 may be formed as a single layer or a multilayer.

The first doping pillar 210 may be provided with (e.g., be positioned in) the first conductivity type semiconductor layer 131. The first doping pillar 210 may be positioned within the first conductivity type semiconductor layer 131. The first conductivity type semiconductor layer 131 may surround the upper surface, the lower surface, and both (or opposite) side surfaces in (or facing toward) the first direction D1 of the first doping pillar 210.

The first doping pillar 210 may be positioned below the third direction D3 of the second conductivity type doped well region 133. The first doping pillar 210 may extend from below the lower surface of the second conductivity type doped well region 133 toward the lower surface of the first conductivity type semiconductor layer 131. For example, the first doping pillar 210 may extend in the third direction D3 to a certain depth from below the lower surface of the second conductivity type doped well region 133.

The level in the third direction D3 of the upper surface of the first doping pillar 210 may be lower than the level in the third direction D3 of the upper surface of the first conductivity type semiconductor layer 131 and the second conductivity type doped well region 133. A level in the third direction D3 of an upper surface of the first doping pillar 210 may be lower than a level in the third direction D3 of a lower surface of the second conductivity type doped well region 133. A level in the third direction D3 of a lower surface of the first doping pillar 210 may be higher than a level in the third direction D3 of a lower surface of the first conductivity type semiconductor layer 131.

The first doping pillars 210 may be spaced apart from each other in the first direction D1. The gate structure 153 may be positioned between the first doping pillars 210. At least a portion of the side surface in the first direction D1 of the first doping pillar 210 may contact the side surface in the first direction D1 of the gate structure 153. The first doping pillar 210 may be connected to gate structures 153 positioned adjacent in the first direction D1. For example, two of the gate structures 153 positioned adjacent to each other in the first direction D1 may be connected to a corresponding one of the first doping pillars 210. The first doping pillar 210 may extend along the gate structure 153 in the second direction D2.

In addition, the second doping pillar 230 may be positioned between the first doping pillars 210. A portion of the first conductivity type semiconductor layer 131 may be positioned between a corresponding one of the first doping pillars 210 and a corresponding one of the second doping pillar 230. At least a portion of the side surface in (or facing toward) the first direction D1 of the first doping pillars 210 and the lower surface of the first doping pillar 210 may be in contact with the first conductivity type semiconductor layer 131.

The first doping pillar (or doped pillar) 210 may include SiC. For example, the first doping pillar 210 may include 4H SiC. For example, the first doping pillar 210 may be doped as p-type. The first doping pillar 210 may be highly doped as p-type. The doping concentration of the first doping pillar 210 may be 1×10¹⁸ cm⁻³ or more and 5× 10²⁰ cm⁻³ or less. As another example, the first doping pillar 210 may be doped as n-type. The first doping pillar 210 may be heavily doped as n-type. The doping concentration of the first doping pillar 210 may be 1×10¹⁸ cm⁻³ or more and 5×10²⁰ cm⁻³ or less. The material, doping type, or doping concentration of the first doping pillar 210 is not limited thereto, and may be variously changed.

For example, in a SiC power semiconductor device, it is preferable to lower the on-resistance (Rₒₙ) in order to reduce power loss, decrease heat generation, and improve fast switching performance. In order to reduce on-resistance, there are design methods such as reducing the channel length or expanding the width of the JFET (junction field effect transistor) region, and one of these is forming a deep junction (or a highly doped region extending to a deep location of a drift region). For example, the first doping pillar 210 having a doping concentration higher than the doping concentration of the first conductivity type semiconductor layer 131 may be formed extending deeper toward the substrate 110 to reduce the on-resistance of the semiconductor device.

In an ion implantation process, a doping projected range (Rp) and a doping range straggle (ΔRp) are typically determined according to the energy of the ion implantation equipment, the dose of the dopant, and/or the species of the dopant. For example, the energy of the ion implantation equipment may be the kinetic energy imparted to the ions by an acceleration voltage during the ion implantation process.

For example, in a process step to form the first doping pillar 210 by ion implanting, under a condition of other parameters (such as hard mask thickness, the same energy, and so on), using a dopant ion having a relatively small size may be favorable to form a deep doped region due to a large doping projected range (Rp) of the ion. However, using the small size ion may involve a greater number of implantation cycles due to its small doping range straggle (ΔRp). The greater number of implantation cycles may result in an increase in processing time and therefore increased costs.

On the other hand, under the same condition of other parameters, using a dopant ion having a relatively large size may involve less implantation cycles. However, using the small size ion may be unfavorable to form a deep doped region due to a small doping projected range (Rp) of the ion, and it may be disadvantageous in terms of lowering the on-resistance. In addition, due to the large size of the ion, a surface damage may be induced, and it may be disadvantageous in terms of reliability.

In an ion implantation process onto a target (e.g., the first conductivity type semiconductor layer 131), the doping projected range (Rp) may be an average penetration depth, along the implantation direction, at which implanted dopant ions come to rest in the target. The doping range straggle (ΔRp) may be a statistical spread, such as a standard deviation, of the distribution of dopant penetration depths with respect to the doping projected range (Rp).

Unless otherwise specified, when Rp or ΔRp is described as being greater or smaller, the comparison may be based on the assumption that the species of dopant ions may vary, while other conditions (e.g., the presence of a masking layer on the target, implantation kinetic energy, and the like) are substantially the same.

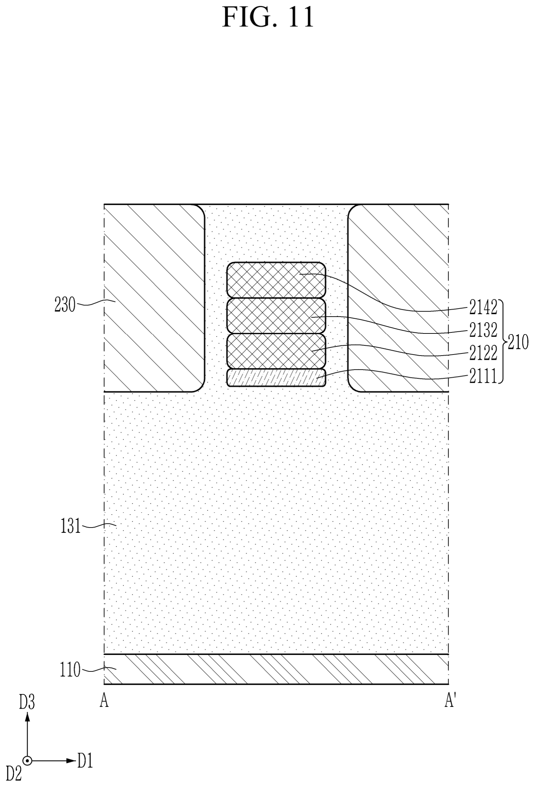

A semiconductor device according to one embodiment, as described previously with reference to FIG. 2 (and as will be described later with reference to FIGS. 11, 19 and 20), may include the first doping pillar 210 formed by varying the doping projected range (Rp) and doping range straggle (ΔRp), or both, and performing ion implantation of the dopant multiple times. In a cross-section cut (or a cross-section view or a cross-section) along the first direction D1 and the third direction D3 such as FIG. 2, the first doping pillar 210 may have a side surface facing toward the first direction D1. By changing the doping projected range (Rp) and doping range straggle (ΔRp), or both, and performing ion implantation of the dopant multiple times to form the first doping pillar 210, the side surface of the first doping pillar 210 may have convex portions (or convex portions) 210V protruding toward the first conductivity type semiconductor layer 131 in the first direction D1, and may have concave portions 210C recessed with respect to the first conductivity type semiconductor layer 131 in the first direction D1. The side surface having the convex portions 210V and the concave portions 210C may extend along the third direction D3.

The side surface of the first doping pillar 210 may be uneven (or irregular) along the third direction D3. A width of the first doping pillar 210 in the first direction D1 may repeatedly increase and decrease along the third direction D3. At the convex portions, the length in the first direction D1 may gradually increase as the level in the third direction D3 rises and then decrease as the level in the third direction D3 further rises, and a discontinuity or irregularity in continuity of this variation may appear at a concave portion (or concave point). For example, the side surface in first direction D1 of the first doping pillar 210 may have a profile in which convex portions 210V, protruding toward the first conductivity type semiconductor layer 131 along the third direction D3, and concave portions 210C, recessed with respect to the first conductivity type semiconductor layer 131 along the third direction D3, are alternately arranged. For example, the side surface of the first doping pillar 210 may be uneven along the third direction D3. A length (or width) in the first direction D1 of the first doping pillar 210 may increase and then decrease, decrease and then increase, increase and then decrease, and decrease and then increase along the third direction D3, and such pattern may be repeated at least twice. The length in the first direction D1 of the first doping pillar 210 may increase and then decrease at the convex portions 210V, and may decrease and then increase at the concave portions 210C.

Here, the length in the first direction D1 of the first doping pillar 210 may be a length in the first direction D1 from a point on one side surface of the first doping pillar 210 to a point on the other side surface (or opposite side surface in the first direction D1) of the first doping pillar 210, and the two points are at the same height level in the third direction D3 (e.g., a level in the third direction D3 of the point on one side surface and the point on the other side surface may be the same).

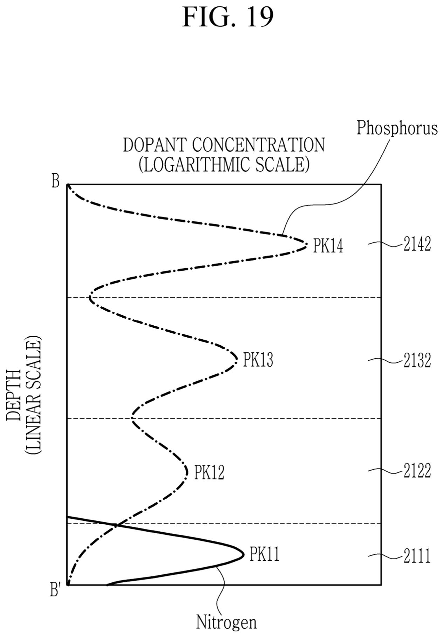

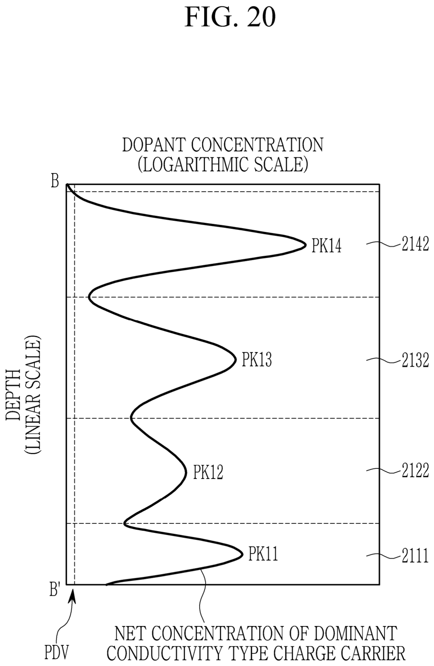

For example, the protrusions 210V of the first doping pillar 210 may be positioned at a level in the third direction D3 corresponding to the doping projected range (Rp) in each ion implantation process. The first doping pillar 210 may have a plurality of protrusions 210V in a number proportional to the number of ion implantation times, as it is formed by multiple ion implantation processes. In addition, the recesses (or concave portions) 210C of the first doping pillar 210 may be positioned at levels in the third direction D3 where minima valleys (as described with reference to FIGS. 19 and 20) of a dominant charge carrier concentration curve are located (e.g., where the doping range straggles (ΔRp) of the respective ion implantation processes are overlapped). The first doping pillar 210 may have concave portions 210C in a number proportional to the number of times of ion implantation, as it is formed by multiple ion implantations.

The first doping pillar 210 may include pillar regions 2111, 2122, 2132, 2142 each having protrusions 210V. Each of the pillar regions 2111, 2122, 2132, 2142 may include two protrusions 210V each of which is positioned on a corresponding one of opposite side surfaces in the first direction D1, respectively. The pillar regions 2111, 2122, 2132, 2142 may be stacked in the third direction D3 to constitute the first doping pillar 210. On each of the opposite side surfaces in the first direction D1, at the boundaries between adjacent two of the pillar regions 2111, 2122, 2132, 2142, concave portions 210C may be positioned. When the pillar regions 2111, 2122, 2132, 2142 include the same dopant, the boundary between the pillar regions 2111, 2122, 2132, 2142 may not be clearly distinguished. In this case, the boundary between the pillar regions 2111, 2122, 2132, 2142 may be defined as a line segment connecting one recessed portion 210C on one side surface in the first direction D1 and another recessed portion (or concave portion) 210C on the other side surface at the shortest distance therefrom.

For example, a method of changing the doping projected range (Rp) or the doping range straggle (ΔRp) may be to use different dopants. For example, two or more species of dopant ions may be used to form the first doping pillar 210. In this case, as the doping projected range (Rp) or doping range straggle (ΔRp) is varied by ion implantation of dopants multiple times using different dopants to form the first doping pillar 210, the first doping pillar 210 may include different dopants. For example, the first doping pillar 210 includes a first dopant and a second dopant, and the first dopant and the second dopant may be different dopants of the same conductivity type. For example, when the first dopant and the second dopant are n-type dopants, the first dopant and the second dopant each may be a group 5 element including nitrogen (N), phosphorus (P), arsenic (As), or a combination thereof. When the first dopant and the second dopant are p-type dopants, the first dopant and the second dopant each may be a Group 3 element including boron (B), aluminum (Al), gallium (Ga), or a combination thereof. In addition, when the first dopant and the second dopant are n-type dopants, the first dopant may be nitrogen (N), and the second dopant may be phosphorus (P) or arsenic (As). Alternatively, when the first dopant and the second dopant are p-type dopants, the first dopant may be boron (B), and the second dopant may be aluminum (Al) or gallium (Ga).

In this case, the first doping pillar 210 may be formed deeper by using nitrogen (N), which has a relatively large doping projected range (Rp). For example, the first doping pillar 210 may be formed deeper due to the influence of the relatively large doping projected range (Rp) of nitrogen (N). In addition, the first doping pillar 210 may be formed deeper due to the influence of the relatively large doping range straggle (ΔRp) of phosphorus (P). This may reduce the number of ion implantations for forming the first doping pillar 210. If only nitrogen (N) is used and phosphorus (P) is not used, a relatively large number of implantation processes (and/or cycles) are needed due to the relatively small doping range straggle (ΔRp) of nitrogen (N). Alternatively, by using both phosphorus (P) and nitrogen (N), due to the relatively large doping range straggle (ΔRp) of phosphorus (P), a doping profile having a sufficient area of the doped region as well as a desirable depth may be achieved with a fewer number of ion implantations. Accordingly, the disadvantages of using only phosphorus (P) (or using only nitrogen (N)) may be overcome, such as the inability to form a deep junction (or deep doped region) due to relatively shallow doping projected range (Rp) of phosphorus (P) and the potential surface damage induced by phosphorus (P) during ion implantation.

For example, a doping profile may be formed up to a depth where doping by ion implantation is possible by using a second dopant having a relatively large doping range straggle (ΔRp), and a deep junction may be formed at a greater depth by using the first dopant having a relatively large doping projected range (Rp), so that the first doping pillar 210 having a deep depth may be formed without surface damage and with a reduced number of ion implantation steps.

In this case, the contents (or concentrations) of respective dopants included in each of the pillar regions 2111, 2122, 2132, 2142 of the first doping pillar 210 may be different from each other. For example, the first pillar region 2111 may include the first dopant (e.g., nitrogen) in a greater amount than the second dopant (e.g., phosphorus), and the second pillar regions 2122, 2132, 2142 may include the second dopant in a greater amount than the first dopant. In the first pillar region 2111, the first dopant may be the dominant dopant over other dopants of the same conductivity type. In the second pillar regions 2122, 2132, 2142, the second dopant may be the dominant dopant over other dopants of the same conductivity type. For example, the first pillar region 2111 may be a region mainly formed when the first dopant is ion implanted, and the second pillar regions 2122, 2132, 2142 may be regions mainly formed when the second dopant is ion implanted. However, since the region formed by ion implantation of the first dopant and the region formed by ion implantation of the second dopant partially overlap due to the doping range straggle (ΔRp), the first pillar region 2111 includes both the first dopant and the second dopant, but may include the first dopant in a greater amount (per unit volume) than the second dopant, and the second pillar regions 2122, 2132, 2142 include both the first dopant and the second dopant, but may include the second dopant in a greater amount (per unit volume) than the first dopant. Here, in the first pillar region 2111, the content (at% per unit volume) of the first dopant may be greater than the content (at% per unit volume) of the second dopant, and in the second pillar regions 2122, 2132, 2142, the content (at% per unit volume) of the second dopant may be greater than the content (at% per unit volume) of the first dopant.

The first doping pillar 210 may be formed such that the first pillar regions 2111 and the second pillar regions 2122, 2132, 2142 are stacked along the third direction D3. For example, the first doping pillar 210 may include the first pillar region 2111 at the very bottom in the third direction D3, and may include a plurality of second pillar regions 2122, 2132, 2142 stacked on the first pillar region 2111. For example, the first pillar region 2111 positioned at the bottom may be formed with (or primarily by) the first dopant having a relatively (or significantly) larger doping projected range (Rp), and second pillar regions 2122, 2132, 2142 on the first pillar region 2111 may be formed with (or primarily by) the second dopant having a relatively (or significantly) larger doping range straggle (ΔRp). In this case, the first doping pillar 210 may be formed deeper by using the first dopant, which has a relatively large doping projected range (Rp). This may reduce the number of ion implantations for forming the first dopant. If not using both the first dopant and the second dopant, typically multiple implantation processes are needed due to the relatively small doping range straggle (ΔRp) of the first dopant. Alternatively, by using both the first dopant and the second dopant, because the second dopant has a relatively large doping range straggle (ΔRp), a desirable doping profile may be achieved with a fewer number of ion implantations. Accordingly, the disadvantages of using only the second dopant (or using only the first dopant) may be overcome, such as the inability to form a deep junction due to the relatively shallow doping projected range (Rp) of the first dopant and the potential for surface damage during ion implantation.

A length (thickness) of the first pillar region 2111 in the third direction D3 may be smaller than a length (thickness) of each of the second pillar regions 2122, 2132, 2142 in the third direction D3. This is because the doping range straggle (ΔRp) of the first dopant, which included in the first pillar region 2111 in greater amount, is relatively (or significantly) smaller than the doping range straggle (ΔRp) of the second dopant, which included in the second pillar regions 2122, 2132, 2142 in greater amount.

In some embodiments, the semiconductor device may further include a second doping pillar positioned in the first conductivity type semiconductor layer 131.

The second doping pillar 230 may be provided with (e.g., be positioned within) the first conductivity type semiconductor layer 131. The first conductivity type semiconductor layer 131 may surround an upper surface, a lower surface, and opposite side surfaces in the first direction D1 of the second doping pillar 230.

The second doping pillar 230 may be positioned under (in the third direction D3) the second conductivity type doped well region 133. The upper surface of the second doping pillar 230 may be in contact with the lower surface of the second conductivity type doped well region 133. The second doping pillar 230 may extend from below the lower surface of the second conductivity type doped well region 133 toward the lower surface of the first conductivity type semiconductor layer 131. For example, the second doping pillar 230 may extend from below the lower surface of the second conductivity type doped well region 133 to a certain depth in the third direction D3. The second doping pillar 230 may be formed in at least a portion of the region of the first conductivity type semiconductor layer 131 by an ion implantation method.

A level in the third direction D3 of the upper surface of the second doping pillar 230 may be lower than the level in the third direction D3 of upper surfaces of the first conductivity type semiconductor layer 131 and the second conductivity type doped well region 133. The level in the third direction D3 of the upper surface of the second doping pillar 230 may be lower than or equal to the level in the third direction D3 of the lower surface of the second conductivity type doped well region 133. The level in the third direction D3 of the lower surface of the second doping pillar 230 may be higher than the level in the third direction D3 of the lower surface of the first conductivity type semiconductor layer 131.

The level in the third direction D3 of the upper surface of the second doping pillar 230 may be higher than or equal to the level in the third direction D3 of the upper surface of the first doping pillar 210. The level in the third direction D3 of the lower surface of the second doping pillar 230 may be lower than, higher than, or equal to the level in the third direction D3 of the lower surface of the first doping pillar 210.

The second doping pillars 230 may be spaced apart from each other in the first direction D1. The gate structure 153 may be positioned between the second doping pillars 230. At least a portion of the side surface in first direction D1 of the second doping pillar 230 may be in contact with the side surface in first direction D1 of the gate structure 153. The second doping pillar 230 may be connected to gate structures 153 positioned adjacent in the first direction D1. For example, two of the gate structures 153 positioned adjacent to each other in the first direction D1 may be connected to a corresponding one of the second doping pillars 230. Accordingly, the lower surface of each of the gate structures 153 may contact the first conductivity type semiconductor layer 131, the first doping pillar 210, and the second doping pillar 230. The second doping pillar 230 may extend in the second direction D2 along the gate structure 153.

In addition, the first doping pillar 210 may be positioned between the second doping pillars 230. A portion of the first conductivity type semiconductor layer 131 may be positioned between a corresponding one of the first doping pillars 210 and a corresponding one of the second doping pillars 230. At least a portion of the side surface in (or facing toward) the first direction D1 of the second doping pillars 230 and the lower surface of the second doping pillar 230 may be in contact with the first conductivity type semiconductor layer 131.

The second doping pillar 230 may include SiC. For example, the second doping pillar 230 may include 4H SiC. For example, the second doping pillar 230 may be doped with a different type than the first doping pillar 210. For example, when the first doping pillar 210 is doped as p-type, the second doping pillar 230 may be doped as n-type. Alternatively, when the first doping pillar 210 is doped as n-type, the second doping pillar 230 may be doped as p-type. When the second doping pillar 230 is heavily doped as p-type, the doping concentration of the second doping pillar 230 may be 1×10¹⁸ cm⁻³ or more and 5×10²⁰ cm⁻³ or less. When the second doping pillar 230 is highly doped as n-type, the doping concentration of the second doping pillar 230 may be 1×10¹⁸ cm⁻³ or more and 5×10²⁰ cm⁻³ or less. The material, doping type, or doping concentration of the second doping pillar 230 are not limited thereto, and may be variously changed.

As described above, the semiconductor device may have a super junction structure in which the first doping pillar 210 and the second doping pillar 230 are alternately arranged in the first direction D1 in order to overcome the trade-off between on-resistance and breakdown voltage (BV).

Accordingly, the semiconductor device may have a structure in which the second doping pillar 230, the first conductivity type semiconductor layer 131, the first doping pillar 210, and the first conductivity type semiconductor layer 131 are sequentially arranged in the first direction D1.

In this case as well, the doping projected range (Rp) and doping range straggle (ΔRp), or both, may be varied, and the dopant may be ion implanted multiple times to form the first doping pillar 210. In a cross-section cut, the second doping pillar 230 may have a side surface facing toward the first direction D1. Though not shown in the drawings, the side surface of the second doping pillar 230 may have convex portions protruding toward the first conductivity type semiconductor layer 131 in the first direction D1, and concave portions recessed with respect to the first conductivity type semiconductor layer 131 in the first direction D1. The side surface having the convex portions and the concave portions may extend along the third direction D3. In addition, the second doping pillar 230 may include pillar regions each having protrusions.

For example, when forming the second doping pillar 230 by performing ion implantation of dopants multiple times using different dopants having different doping projected ranges (Rp) or doping range straggles (ΔRp), the second doping pillar 230 may include different dopants. In this case, the contents (or concentrations) of respective dopants included in each of the pillar regions of the second doping pillar 230 may be different from each other.

A first interlayer insulating layer 140 may be positioned on the first conductivity type semiconductor layer 131. For example, the first interlayer insulating layer 140 may be positioned on at least a portion of the first conductivity type doped layer 137 and the second conductivity type doped layer 135. The first interlayer insulating layer 140 may have a lower surface in contact with at least a portion of the upper surface of the second conductivity type doped layer 135.

In addition, the first interlayer insulating layer 140 may be positioned on the gate structure 153. The gate electrode 150 may be insulated from the source electrode 170 by the first interlayer insulating layer 140. In some embodiments, the gate electrode 150 may be recessed such that the level of the upper surface of the gate electrode 150 in the third direction D3 is lower than the level in the third direction D3 of the upper surface of the gate trench 290 or the level in the third direction D3 of the upper surface of the first conductivity type semiconductor layer 131. In this case, at least a portion of the first interlayer insulating layer 140 may be positioned within the gate trench 290.

The first interlayer insulating layer 140 may include an insulating material. For example, the first interlayer insulating layer 140 may include the same insulating material as the gate insulating layer 151. For example, the first interlayer insulating layer 140 may include SiO₂. However, this is not limited thereto, and the first interlayer insulating layer 140 may include various species of insulating material for insulating the gate electrode 150 from the source electrode 170. For example, the first interlayer insulating layer 140 may include SiOP, SiN, SiON, or a combination thereof. The first interlayer insulating layer 140 may be formed as a single layer or a multilayer. When the first interlayer insulating layer 140 is formed of the same material as the gate insulating layer 151, the boundary between the first interlayer insulating layer 140 and the gate insulating layer 151 at the portion where the first interlayer insulating layer 140 contacts the gate insulating layer 151 may not be clearly distinguishable.

The source electrode 170 may be positioned on the second conductivity type doped well region 133. The second conductivity type doped layer 135 and the first conductivity type doped layer 137 may be positioned between the source electrode 170 and the second conductivity type doped well region 133. The source electrode 170 may be electrically connected to the second conductivity type doped well region 133 by the second conductivity type doped layer 135. A current or voltage may be supplied to the cell region 111 through the source electrode 170.

The source electrode 170 may be positioned on both sides (or opposite sides) of the gate structure 153 in the first direction D1. However, this is not limited thereto, and the source electrode 170 may be positioned only on one side in the first direction D1 of the gate structure 153. The source electrode 170 may be positioned on the gate structure 153.

The first interlayer insulating layer 140 may be positioned between the source electrode 170 and the gate structure 153. The source electrode 170 may be spaced apart from the gate structure 153 by the first interlayer insulating layer 140. The source electrode 170 may contact the side surface and upper surface of the first interlayer insulating layer 140.

For example, the source electrode 170 may include tungsten (W), aluminum (Al), copper (Cu), cobalt (Co), titanium (Ti), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), ruthenium (Ru), iridium (Ir), osmium (Os), silver (Ag), gold (Au), zinc (Zn), vanadium (V), titanium aluminum (TiAl), titanium aluminum carbonitride (TiAlC-N), titanium aluminum carbide (TiAlC), titanium carbide (TiC), titanium nitride (TiN), titanium silicon nitride (TiSiN), titanium aluminum nitride (TiAIN), tungsten nitride (WN), or a combination thereof, but is not limited thereto. The source electrode 170 may be formed of a single layer or a multilayer.

In some embodiments, the semiconductor device may further include a silicide layer positioned between the source electrode 170 and the second conductivity type doped layer 135, and between the source electrode 170 and the first conductivity type doped layer 137.

The silicide layer may be positioned conformally along the interface between the source electrode 170 and the second conductivity type doped layer 135, and the interface between the source electrode 170 and the first conductivity type doped layer 137. The lower surface of the silicide layer may be in contact with the second conductivity type doped layer 135 and the first conductivity type doped layer 137. The upper surface of the silicide layer may be in contact with the source electrode 170. The silicide layer may include a metal silicide material. For example, the silicide layer may include tungsten silicide (WSi), titanium silicide (TiSi), cobalt silicide (CoSi), nickel silicide (NiSi), or a combination thereof.

For example, in the manufacturing process of a semiconductor device, a silicidation process may be performed on the upper surfaces of the second conductivity type doped layer 135 and the first conductivity type doped layer 137 to form the silicide layer. However, this is not limited thereto. After forming the source electrode 170, in order to reduce the contact resistance, silicide layers may be formed between the second conductivity type doped layer 135 and the source electrode 170 and between the first conductivity type doped layer 137 and the source electrode 170, by an annealing process that is performed subsequent to the forming the source electrode 170. Accordingly, the silicide layer may be formed along the interface between the source electrode 170 and the second conductivity type doped layer 135, and between the source electrode 170 and the first conductivity type doped layer 137.

The drain electrode 180 may be positioned below the second surface (for example, the lower surface) of the substrate 110. An upper surface of the drain electrode 180 may contact the lower surface of the substrate 110. The drain electrode 180 may be ohmically contacted (or connected) with the substrate 110. The region within the substrate 110 in contact with the drain electrode 180 may be doped at a relatively high concentration as compared to other regions. However, this is not limited thereto, and a predetermined other layer may be further positioned between the drain electrode 180 and the substrate 110. For example, a silicide layer may be positioned between the drain electrode 180 and the substrate 110. The silicide layer may include a metal silicide material. An electrical connection between the drain electrode 180 and the substrate 110 may be smoothly (or reliably or stably) established by the metal silicide layer.

The drain electrode 180 may include a conductive material. For example, the drain electrode 180 may include a metal, a metal alloy, a conductive metal nitride, a metal silicide, a doped semiconductor material, a conductive metal oxide, or a conductive metal oxynitride, and the like. The drain electrode 180 may be formed of the same material as the source electrode 170, or may be formed of a different material.

For example, the drain electrode 180 may include titanium (Ti), titanium nitride (TiN), titanium silicon nitride (TiSiN), titanium aluminum nitride (TiAlN), titanium carbide (TiC), titanium aluminum (TiAl), titanium aluminum carbonitride (TiAlC-N), titanium aluminum carbide (TiAlC), tantalum (Ta), tantalum carbide (TaC), tantalum nitride (TaN), tantalum carbonitride (TaCN), tantalum silicon nitride (TaSiN), tantalum titanium nitride (TaTiN), tantalum aluminum nitride (TaAlN), tungsten (W), tungsten nitride (WN), tungsten carbide (WC), aluminum (Al), copper (Cu), cobalt (Co), nickel (Ni), nickel-vanadium (Ni-V), nickel-platinum (Ni-Pt), vanadium (V), zinc (Zn), niobium (Nb), niobium nitride (NbN), niobium carbide (NbC), molybdenum (Mo), molybdenum nitride (MoN), molybdenum carbide (MoC), ruthenium (Ru), platinum (Pt), rhodium (Rh), palladium (Pd), iridium (Ir), osmium (Os), silver (Ag), gold (Au), or a combination thereof, but is not limited thereto. The drain electrode 180 may be formed of a single layer or a multilayer.

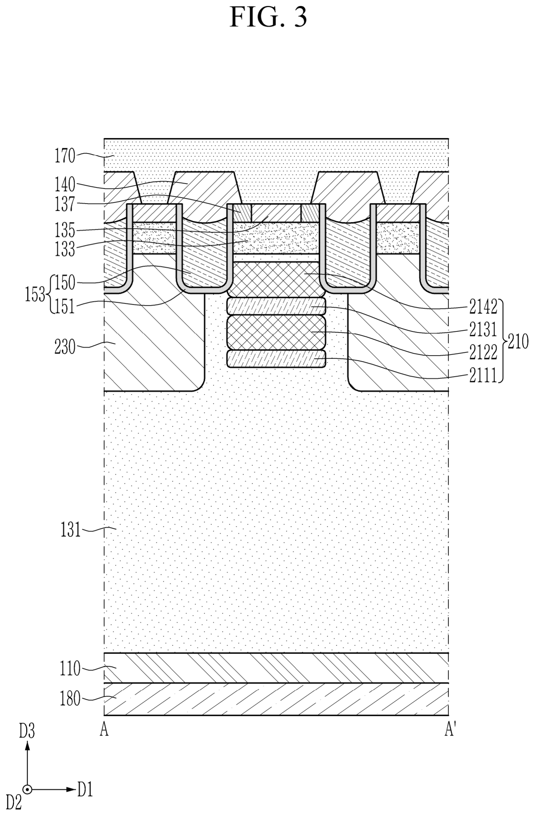

Hereinafter, semiconductor devices according to some embodiments will be described with reference to FIGS. 3 to 9.

FIG. 3 is a cross-sectional view showing a semiconductor device according to one embodiment, and is a drawing corresponding to FIG. 2 (i,e, a cross section along the line A-A' in Figure 1). The embodiment shown in Fig. 3 is substantially the same as (or similar to) the embodiment shown in Fig. 2. Accordingly, a detailed description of the common parts will be omitted, and the differences will be primarily explained. Additionally, the same (or similar) reference numerals are used to denote components identical (or similar) to those in the preceding embodiment.

Referring to FIG. 3, the first doping pillar 210 includes the first pillar regions 2111, 2131 and the second pillar regions 2122, 2142, and the first pillar regions 2111, 2131 and the second pillar regions 2122, 2142 may be alternately stacked in the third direction D3. For example, the first doping pillar 210 may be formed by sequentially stacking the first pillar region 2111, the second pillar region 2122, the first pillar region 2131, and the second pillar region 2142 in the third direction D3.

In FIG. 3, although the first doping pillar 210 is shown as including two first pillar regions 2111, 2131 and two second pillar regions 2122, 2142, it is not limited thereto, and the number of the first pillar regions 2111, 2131 and the second pillar regions 2122, 2142 may be two or more, three or more, four or more, five or more, ten or more, twenty or more, or one hundred or more.

When the first doping pillar 210 includes the first pillar region 2111 at the very bottom, a deep junction may be formed by forming the first pillar region 2111 positioned at the very bottom with (or by implanting) the first dopant having a relatively (or significantly) greater doping projected range (Rp). In addition, when the first doping pillar 210 includes first pillar regions 2111, 2131 and second pillar regions 2122, 2142 alternately stacked, the second pillar regions 2122, 2142 may be formed by implanting the second dopant having a relatively large doping range straggle (ΔRp), such that a doping profile may be implemented with a reduced number of times. By forming the first pillar region 2131 between the second pillar regions 2122, 2142, portions having a low dopant content of the second dopant may be reinforced, and the number of ion implantations for the second dopant having a large size may be reduced, thereby reducing surface damage induced during the ion implantation. For example, the first pillar region 2131 may be formed between the second pillar regions 2122 and 2142 by implanting of the first dopant such that the first doping pillar 210 has enough (or desirable) dopants throughout the entire region of the first doping pillar 210.

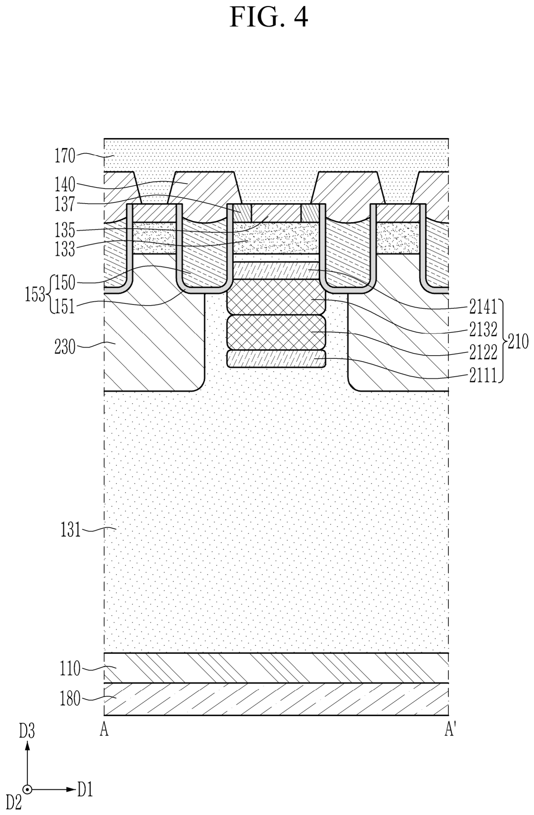

FIG. 4 is a cross-sectional view showing a semiconductor device according to an embodiment, and is a drawing corresponding to FIG. 2 (i,e, a cross section along the line A-A' in Figure 1). The embodiment shown in Fig. 4 is substantially the same as (or similar to) the embodiment shown in Fig. 2. Accordingly, a detailed description of the common parts will be omitted, and the differences will be primarily explained. Additionally, the same reference numerals are used to denote components that are the same as those in the preceding embodiment.

Referring to FIG. 4, the first doping pillar 210 includes the first pillar regions 2111, 2141 and the second pillar regions 2122, 2132, and the first pillar regions 2111, 2141 and the second pillar regions 2122, 2132 may be stacked in the third direction D3.

For example, the first doping pillar 210 may include the first pillar region 2111 on the bottom, include the first pillar region 2141 on the top, and may include a plurality of second pillar regions 2122, 2132 stacked between the first pillar regions 2111, 2141. For example, the first doping pillar 210 may be formed such that the first pillar region 2111, the second pillar region 2122, the second pillar region 2132, and the first pillar region 2141 are sequentially stacked in the third direction D3.

In FIG. 4, the first doping pillar 210 is illustrated as including two first pillar regions 2111, 2141 and two second pillar regions 2122, 2132, but is not limited thereto, and the number of the first pillar regions 2111, 2141 and the second pillar regions 2122, 2132 may be two or more, three or more, four or more, five or more, ten or more, twenty or more, or one hundred or more.

When the first doping pillar 210 includes the first pillar region 2111 at the very bottom, a deep junction may be readily formed. This is because the first pillar region 2111, which is positioned at the very bottom, is formed with (or by implanting) the first dopant having a relatively (or significantly) greater doping projected range (Rp). In addition, when the first doping pillar 210 includes a plurality of second pillar regions 2122, 2132 stacked between the first pillar regions 2111, 2141, the second pillar regions 2122, 2132 may be formed with (or by implanting) the second dopant having a relatively large doping range straggle (ΔRp), so that a doping profile may be implemented with a reduced number of processes. In addition, when the first doping pillar 210 includes the first pillar region 2141 on the very top, by forming the first pillar region 2141 on the second pillar regions 2122, 2132, it is possible to reinforce a portion where the doping content of the second dopant is low, and to reduce surface damage during ion implantation by reducing the number of ion implantation processes for the second dopant of large size. For example, the first pillar region 2141 may be formed on the second pillar regions 2122 (or 2132) by implanting of the first dopant such that the first doping pillar 210 has enough dopants throughout the entire region of the first doping pillar 210.

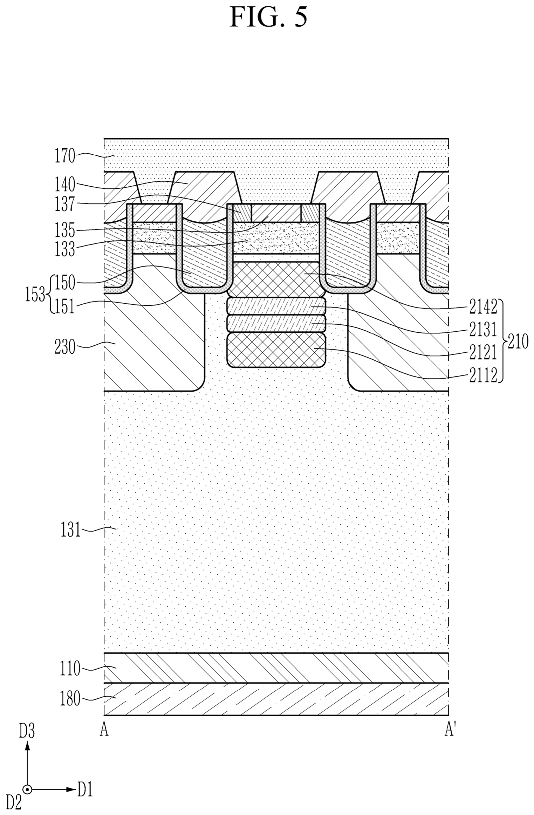

FIG. 5 is a cross-sectional view showing a semiconductor device according to an embodiment, and is a drawing corresponding to FIG. 2 (i,e, a cross section along the line A-A' in Figure 1). The embodiment shown in Fig. 5 is substantially the same as (or similar to) the embodiment shown in Fig. 2. Accordingly, a detailed description of the common parts will be omitted, and the differences will be primarily explained. Additionally, the same reference numerals are used to denote components that are the same as those in the preceding embodiment.

Referring to FIG. 5, the first doping pillar 210 includes the first pillar regions 2121, 2131 and the second pillar regions 2112, 2142, and the first pillar regions 2121, 2131 and the second pillar regions 2112, 2142 may be stacked in the third direction D3.

For example, the first doping pillar 210 may include the second pillar region 2112 at the very bottom, include the second pillar region 2142 at the very top, and may include a plurality of first pillar regions 2121, 2131 stacked between the second pillar regions 2112, 2142. For example, the first doping pillar 210 may be formed such that the second pillar region 2112, the first pillar region 2121, the first pillar region 2131, and the second pillar region 2142 are sequentially stacked in the third direction D3.

In FIG. 5, the first doping pillar 210 is illustrated as including two first pillar regions 2121, 2131 and two second pillar regions 2112, 2142; however, this is not limited thereto, and the number of the first pillar regions 2121, 2131 and the second pillar regions 2112, 2142 may be two or more, three or more, four or more, five or more, ten or more, twenty or more, or one hundred or more.

When the first doping pillar 210 includes the second pillar region 2112 at the very bottom and includes the second pillar region 2142 at the very top, the doping profile may be implemented with fewer repetitions by forming the second pillar regions 2112, 2142 using the second dopant having a relatively large doping range straggle (ΔRp). In addition, when the first doping pillar 210 includes a plurality of first pillar regions 2121, 2131 stacked between the second pillar regions 2112, 2142, it is possible to reinforce portions where the doping content of the second dopant is low, and reduce surface damage during ion implantation by reducing the number of ion implantations of the second dopant having a large size.

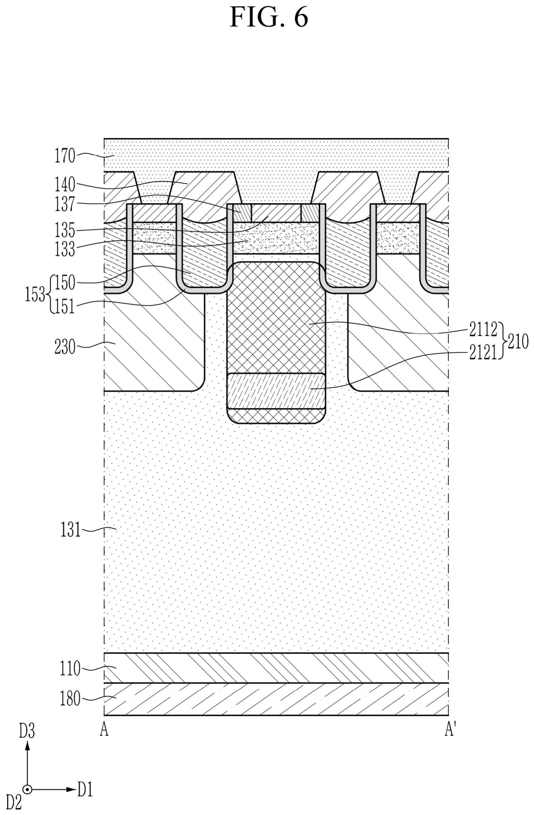

FIG. 6 is a cross-sectional view showing a semiconductor device according to an embodiment, and is a drawing corresponding to FIG. 2 (i,e, a cross section along the line A-A' in Figure 1). The embodiment shown in Fig. 6 is substantially the same as (or similar to) the embodiment shown in Fig. 2. Accordingly, a detailed description of the common parts will be omitted, and the differences will be primarily explained. Additionally, the same reference numerals are used to denote components that are the same as those in the preceding embodiment.

Referring to FIG. 6, the first doping pillar 210 includes the first pillar region 2121 and the second pillar region 2112, and the first pillar region 2121 may be included within (e.g., provided with) the second pillar region 2112. For example, the first pillar region 2121 may be positioned within the second pillar region 2112. For example, the first pillar region 2121 may be positioned closer to the lower surface of the second pillar region 2112 than to the upper surface of the second pillar region 2112. In some embodiments, the second pillar region 2112 may include a plurality of first pillar regions 2121 therein.

In FIG. 6, the first doping pillar 210 is illustrated as including one first pillar region 2121 and one second pillar region 2112, but is not limited thereto, and the number of the first pillar region 2121 and the second pillar region 2112 may be two or more, three or more, four or more, five or more, ten or more, twenty or more, or one hundred or more.

For example, in the case where a channeling ion implantation method is used, the doping projected range (Rp) may be increased compared to a random ion implantation method, so that even when the second pillar region 2112 is formed using the second dopant having relatively large doping range straggle (ΔRp), a deep second pillar region 2112 may be formed comparatively readily. The channeling ion implantation may occur when implanted ions are oriented close to crystallographic axes or planes in an ion implantation target having a crystalline structure, thereby enhancing channeling effect of the ion. The implanted ion in the manner of the channeling ion implantation may penetrate deeper than the implanted ion in the manner of the channeling ion implantation in the random ion implantation.

In some embodiments, though the second dopant is introduced in the manner of the channeling ion implantation, the concentration of the second dopant may not be enough in a deeper portion of the first doping pillar 210. In this case, by further implanting the first dopant to the deeper area, enough concentration may be obtained. For example, as the doping concentration of the second dopant may be lower toward a bottom portion of the second pillar region 2112, the first pillar region 2121 may be formed in the region of lower concentration to compensate for the portion with the low doping concentration of the second dopant.

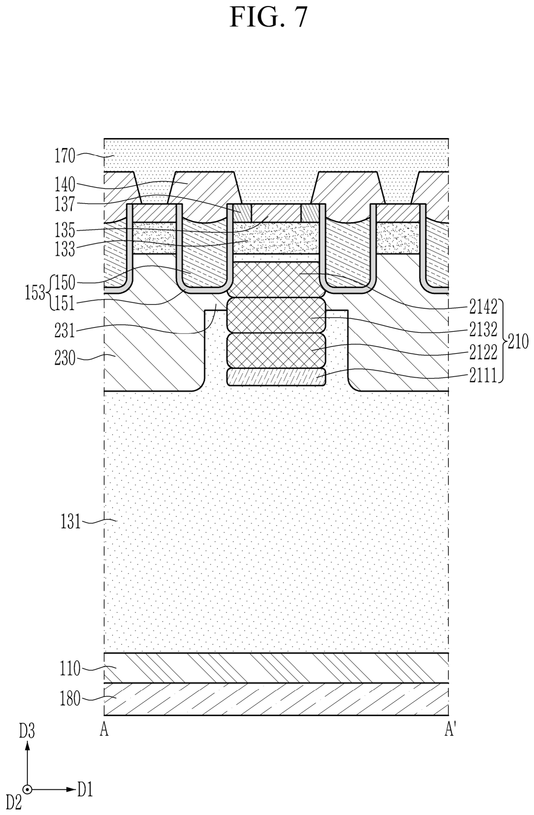

FIG. 7 is a cross-sectional view showing a semiconductor device according to an embodiment, and is a drawing corresponding to FIG. 2 (i,e, a cross section along the line A-A' in Figure 1). The embodiment shown in Fig. 7 is substantially the same as (or similar to) the embodiment shown in Fig. 2. Accordingly, a detailed description of the common parts will be omitted, and the differences will be primarily explained. Additionally, the same reference numerals are used to denote components that are the same as those in the preceding embodiment.

Referring to FIG. 7, the semiconductor device may further include a second conductivity type shield region 231.

The second conductivity type shield region 231 may be positioned on (e.g., provided with) the first conductivity type semiconductor layer 131. The second conductivity type shield region 231 may be positioned adjacent to and below a lower surface of the gate structure 153.

For example, the second conductivity type shield region 231 may surround or be positioned adjacent to the corner between the lower surface and the side surface of the gate structure 153. The corner of the gate structure 153 is a region where an electric field is strongly applied, and the second conductivity type shield region 231 may surround the corner of the gate structure 153 to weaken the electric field at the corner of the gate structure 153.

The upper surface of the second conductivity type shield region 231 may contact the lower surface of the gate structure 153. At least a portion of the lower surface of the second conductivity type shield region 231 may be in contact with the first conductivity type semiconductor layer 131. One side surface in the first direction D1 of the second conductivity type shield region 231 may be connected to (or directly adjacent to) the first doping pillar 210. One side surface in the first direction D1 of the second conductivity type shield region 231 may be connected to (or directly adjacent to) the second doping pillar 230.

The second conductivity type shield region 231 may include SiC. For example, the second conductivity type shield region 231 may include 4H SiC. The second conductivity type shield region 231 may be doped to be p-type. When the second conductivity type shield region 231 is doped with high concentration as (or to be) p-type, the doping concentration of the second doping pillar 230 may be 1×10¹⁸ cm⁻³ or more and 5×10²⁰ cm⁻³ or less. For example, when the second conductivity type shield region 231 is doped with the same type as the second doping pillar 230, the boundary between the second conductivity type shield region 231 and the second doping pillar 230 may not be distinguishable.

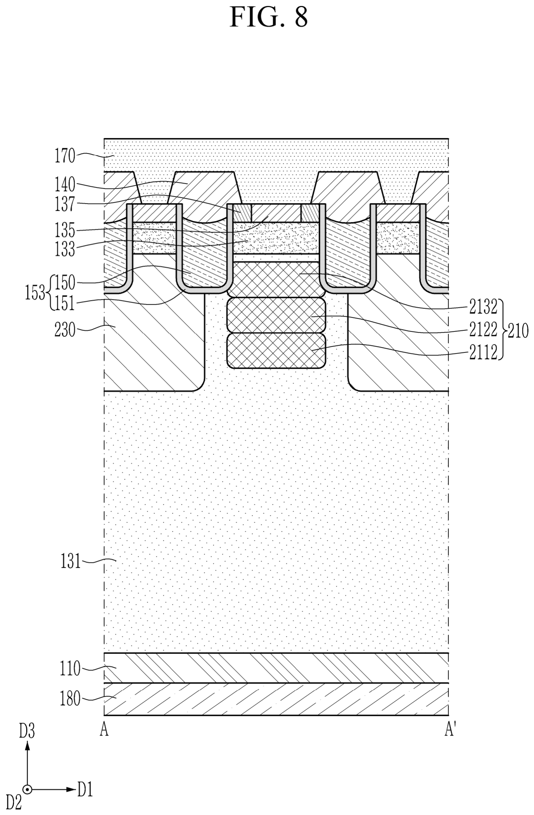

FIG. 8 is a cross-sectional view showing a semiconductor device according to an embodiment, and is a drawing corresponding to FIG. 2 (i,e, a cross section along the line A-A' in Figure 1). The embodiment shown in Fig. 8 is substantially the same as (or similar to) the embodiment shown in Fig. 2. Accordingly, a detailed description of the common parts will be omitted, and the differences will be primarily explained. Additionally, the same reference numerals are used to denote components that are the same as those in the preceding embodiment.

Referring to FIG. 8, the first doping pillar 210 may include the second pillar regions 2112, 2122, 2132, and the first pillar region 2111 may not be included.

For example, in the case where the first doping pillar 210 is formed by changing the doping projected range (Rp) and the doping range straggle (ΔRp), or both, using the second dopant, and implanting the dopant multiple times by ion implantation, the first doping pillar 210 may include the second pillar regions 2112, 2122, 2132, and the first pillar region 2111 may not be included. Accordingly, the first doping pillar 210 may be formed deeper to lower on-resistance, and surface damage during ion implantation may be reduced, thereby securing long-term reliability.

In FIG. 8, although the first doping pillar 210 is shown to include three second pillar regions 2112, 2122, and 2132, it is not limited thereto, and the number of the second pillar regions 2112, 2122, and 2132 may be two or more, three or more, four or more, five or more, ten or more, twenty or more, or one hundred or more.

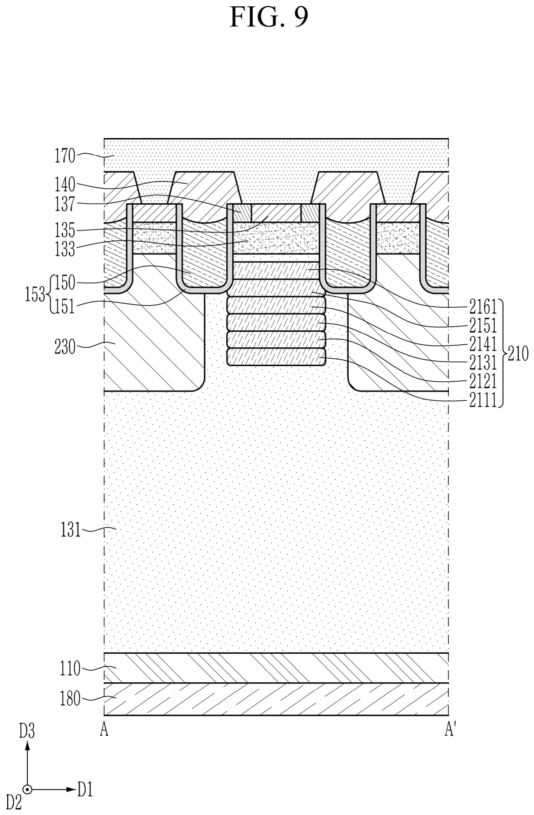

FIG. 9 is a cross-sectional view showing a semiconductor device according to an embodiment, and is a drawing corresponding to FIG. 2 (i,e, a cross section along the line A-A' in Figure 1). The embodiment shown in Fig. 9 is substantially the same as (or similar to) the embodiment shown in Fig. 2. Accordingly, a detailed description of the common parts will be omitted, and the differences will be primarily explained. Additionally, the same reference numerals are used to denote components that are the same as those in the preceding embodiment.

Referring to FIG. 9, the first doping pillar 210 may include the first pillar regions 2111, 2121, 2131, 2141, 2151, 2161, and the second pillar region 2122 may not be included.

For example, in the case where the first doping pillar 210 is formed by changing the doping projected range (Rp) and the doping range straggle (ΔRp), or both, using the first dopant, and implanting the dopant multiple times by ion implantation, the first doping pillar 210 may include first pillar regions 2111, 2121, 2131, 2141, 2151, 2161, and may not include the second pillar region 2122. Accordingly, the first doping pillar 210 may be formed deeper to lower the on-resistance, while reducing surface damage during ion implantation and securing long-term reliability.

In FIG. 9, the first doping pillar 210 is illustrated as including five first pillar regions 2111, 2121, 2131, 2141, 2151, 2161. However, this is not limited thereto, and the number of first pillar regions 2111, 2121, 2131, 2141, 2151, 2161 may be 2 or more, 3 or more, 4 or more, 5 or more, 10 or more, 20 or more, or 100 or more.

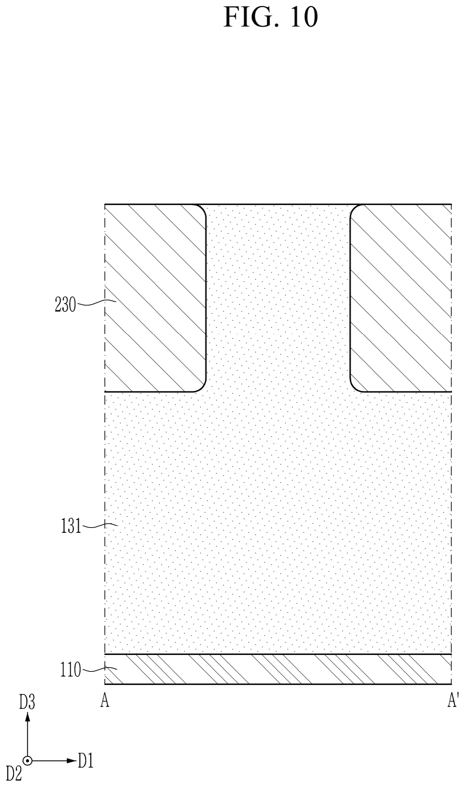

Hereinafter, a method of manufacturing a semiconductor device according to some embodiments will be described with reference to FIGS. 10 to 18.

FIGS. 10 to 18 are cross-sectional views showing a method of manufacturing a semiconductor device according to an embodiment in process order.

Referring to FIG. 10, the first conductivity type semiconductor layer 131 may be formed on (or provided with) the substrate 110.

For example, on the first surface of the substrate 110 (for example, on the upper surface), the first conductivity type semiconductor layer 131 may be formed by an epitaxial growth method. The first conductivity type semiconductor layer 131 may be formed to be in contact with or directly adjacent to the substrate 110. In some embodiments, after forming another layer on the substrate 110, the first conductivity type semiconductor layer 131 may be formed on that layer.

In some embodiments, the second doping pillars 230 may be further formed on the first conductivity type semiconductor layer 131.

For example, the second doping pillars 230 may be formed by an ion implantation method. Using a photolithography process, it may be possible to define a region on the first conductivity type semiconductor layer 131 where the second doping pillars 230 are to be formed. For example, the second doping pillars 230 may be formed to be spaced apart from each other at predetermined intervals in the first direction D1.

Thereafter, dopant ions may be subjected to ion implantation in the region. The second doping pillars 230 may have a predetermined depth. For example, the depth of the second doping pillars 230 may be determined by the number of ions implanted and/or the speed (or the kinetic energy imparted to ions by an acceleration voltage during an ion implantation process) at which the ions are accelerated. The substrate 110 during ion implantation may not be heated. Alternatively, when ions are implanted at a high concentration, the substrate 110 may be heated to 200 °C to 800 °C. As described previously with reference to FIGS. 1 to 9, the second doping pillars 230 may be formed by using a plurality of species of dopant ions having different sizes, different doping projected range (Rp), and/or different straggle (ΔRp) from each other.

Referring to FIG. 11, the first doping pillar 210 may be formed in (e.g., provided with) the first conductivity type semiconductor layer 131.

For example, the first conductivity type semiconductor layer 131 may be formed by an ion implantation method. The first conductivity type semiconductor layer 131 may be formed by performing ion implantation multiple times. As described previously with reference to FIGS. 1 to 9, the first doping pillars 210 may be formed by using a plurality of species of dopant ions having different sizes, different doping projected range (Rp), and/or different straggle (ΔRp) from each other. For example, the plurality of ion implantation may be performed while changing the doping projected range (Rp), the doping range straggle (ΔRp), or both. For example, the doping projected range (Rp) or the doping range straggle (ΔRp) may be changed by changing the thickness of the hard mask, changing the energy, or changing the species of the dopant.

By using a photolithography process, a region in which first doping pillars 210 may be formed may be defined on the first conductivity type semiconductor layer 131. The first doping pillars 210 may be formed to be spaced apart from each other at a predetermined interval in the first direction D1. In some embodiments (where the second doping pillar 230 is formed), the first doping pillars 210 may be formed between the second doping pillars 230 in the first direction D1.

Thereafter, a plurality of ion implantations may be performed into the region while changing the doping projected range (Rp) and the doping range straggle (ΔRp), or both. For example, the first pillar region 2111 may first be formed in a deeper region (where the second dopant is unreachable or hard to be introduced by an implantation process) by using the first dopant having a smaller particle size (or dopant size or impurity size) and a deeper (or greater) doping projected range (Rp). Subsequently, the second pillar regions 2122, 2132, 2142 may be formed by using the second dopant having a large doping range straggle (ΔRp) at a depth that is dopable by the second dopant (or at a depth where the second dopant may be introduced easily by an implantation process).

When the first doping pillar 210 includes the first pillar region 2111 at the very bottom, a deep junction may be formed by forming the first pillar region 2111, which is positioned at the very bottom, with the first dopant having a relatively (or significantly) greater doping projected range (Rp). In addition, when the first doping pillar 210 includes a plurality of second pillar regions 2122, 2132, 2142 stacked on the first pillar regions 2111, the second pillar regions 2122, 2132, 2142 may be formed with the second dopant having a relatively large doping range straggle (ΔRp), such that a doping profile may be implemented with fewer processes, and the number of ion implantations for the relatively large second dopant may be reduced, thereby reducing surface damage during ion implantation.

In some embodiments, ion implantation of the first dopant using high energy to form a deep junction may be performed first. However, this is not limited thereto. For example, second pillar regions 2122, 2132, 2142 may first be formed using the second dopant, followed by forming the first pillar region 2111 using the first dopant.

In some embodiments, ion implantation using the first dopant and ion implantation using the second dopant may be repeatedly performed to form the first doping pillar 210 according to the embodiment shown in FIG. 3.

In some embodiments, ion implantation may be performed using the first dopant, followed by ion implantation may be performed twice using the second dopant. Subsequently, ion implantation may be performed using the first dopant to form the first doping pillar 210 according to the embodiment shown in FIG. 4.

In some embodiments, ion implantation may be performed using the second dopant, followed by ion implantation using the first dopant. Subsequently, ion implantation may be performed using the second dopant to form the first doping pillar 210 according to the embodiment shown in FIG. 5.

In some embodiments, in the case of using a channeling ion implantation method (in which the ion implantation angle is tilted so that ions penetrate deep with reduced collisions with the atoms in the ion implantation target along the gaps (or crystal direction) of the crystal lattice during ion implantation), first, ion implantation may be performed using the first dopant having a large doping projected range (Rp), and then ion implantation may be performed using the second dopant, to form the first doping pillar 210 according to the embodiment illustrated in FIG. 5. However, this is not limited thereto, and the second pillar region 2112 may be first formed using the second dopant, and then the first pillar region 2121 may be formed using the first dopant.

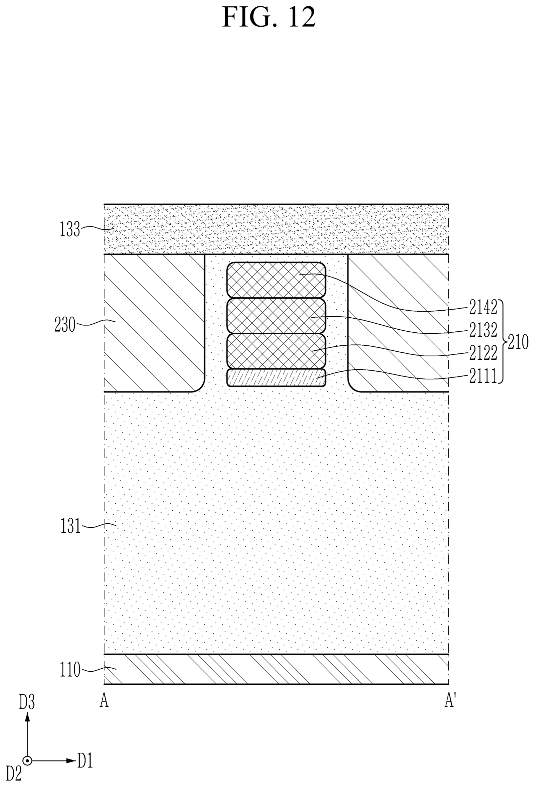

Referring to FIG. 12, the second conductivity type doped well region 133 may be formed in (e.g., provided with) the first conductivity type semiconductor layer 131.

For example, the second conductivity type doped well region 133 may be formed by an ion implantation method. For example, by using a photolithography process, a region in which the second conductivity type doped well region 133 may be formed may be defined on the first conductivity type semiconductor layer 131.

Thereafter, second conductivity type dopant ions may be implanted into the region. The second conductivity type doped well region 133 may be provided with the second doping pillar 230 and have a predetermined depth. For example, the second conductivity type doped well region 133 may be positioned on the upper surfaces of the first conductivity type semiconductor layer 131 and the second doping pillar 230, and may be formed to be positioned on the first doping pillar 210.

For example, the depth of the second conductivity type doped well region 133 may be determined by the number of ions implanted and/or the speed (kinetic energy) at which the ions are accelerated. The substrate 110 during ion implantation is not heated, or, in the case of ion implantation at a high concentration, the substrate 110 may be heated to 200 °C to 800 °C.

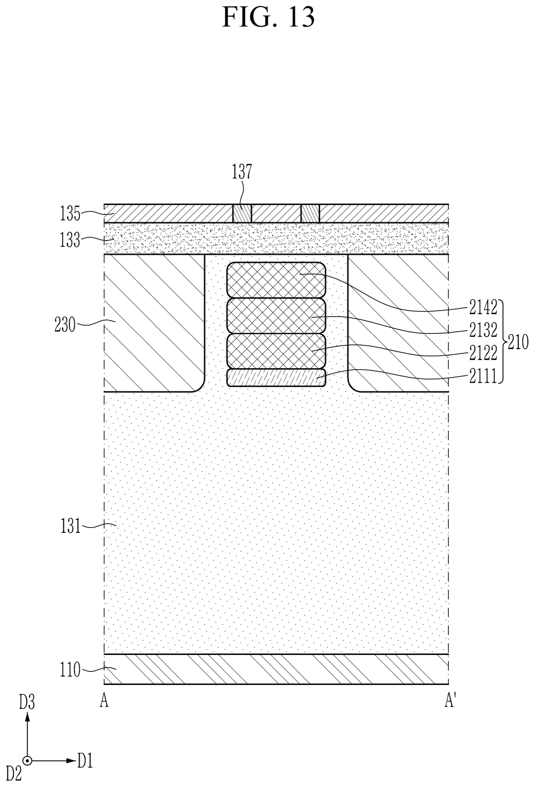

Referring to FIG. 13, in some embodiments, the second conductivity type doped layer 135 and the first conductivity type doped layer 137 may be further formed in (e.g., provided with) the second conductivity type doped well region 133.

For example, the second conductivity type doped layer 135 may be formed within the second conductivity type doped well region 133 by an ion implantation method. The second conductivity type doped layer 135 may be formed in at least a portion of the region of the second conductivity type doped well region 133. For example, the second conductivity type doped layer 135 may be formed below a position where the source electrode 170 is to be formed later.

Next, the first conductivity type doped layer 137 may be formed in (e.g., provided with) the second conductivity type doped well region 133.

For example, the first conductivity type doped layer 137 may be formed within the second conductivity type doped well region 133 by an ion implantation method. The first conductivity type doped layer 137 may be formed on (or in) at least a portion of the second conductivity type doped well region 133. For example, the first conductivity type doped layer 137 may be formed at a position where it is overlapped with the gate electrode 150 in the third direction D3.

In some embodiments, after ion implantation (or after forming the first conductivity type doped layer 137 and the second conductivity type doped well region 133), annealing may be performed for 30 minutes to 60 minutes at a temperature of 1500 °C to 2200 °C in an inert gas atmosphere such as argon (Ar) gas or nitrogen gas, or in a vacuum, so that the ion-implanted dopant may be electrically activated. For example, annealing may be performed in a state in which the substrate 110 and the layers formed on the substrate 110 are covered with a carbon film. By means of the carbon layer, surface damage of SiC potentially generated by moisture or oxygen remaining within the annealing apparatus during annealing may be prevented or reduced.

Next, by sacrificially oxidizing the surface of the first conductivity type semiconductor layer 131 (in which the second conductivity type doped well region 133, the second conductivity type doped layer 135, and the first conductivity type doped layer 137 are formed), a thermal oxidation layer is formed, and by removing this thermal oxidation layer with hydrofluoric acid, the surface altered layer (or surface damage) induced by the ion implantation processes into the first conductivity type semiconductor layer 131 may be removed, thereby exposing (or obtaining) a clean surface.

In some embodiments, a field insulating layer may be formed on the first conductivity type semiconductor layer 131. For example, the field insulating layer may cover the first conductivity type semiconductor layer 131, and may expose a portion of the second conductivity type doped well region 133, the first conductivity type doped layer 137, and the second conductivity type doped layer 135.

Referring to FIG. 14, the gate trench 290 may be formed on an upper surface of the first conductivity type semiconductor layer 131.

For example, the gate trench 290 may be formed by etching the first conductivity type semiconductor layer 131 from the upper surface of the first conductivity type semiconductor layer 131 to below the lower surface of the second conductivity type doped well regions 133. Patterning of the first conductivity type semiconductor layer 131 may be performed, for example, by using a photolithography method or a dry etching method.

The gate trench 290 may be formed such that the lower surface thereof is in contact with the first conductivity type semiconductor layer 131, the first doping pillar 210, and the second doping pillar 230. In addition, the gate trench 290 may be formed such that the first conductivity type doped layer 137 is positioned adjacent to the gate trench 290. Accordingly, the gate trench 290 may be formed such that both (opposite) side surfaces in the first direction D1 are in contact with the second conductivity type doped well region 133, one side surface in the first direction D1 is in contact with the first conductivity type doped layer 137, and the other side surface in the first direction D1 is in contact with the second conductivity type doped layer 135. In addition, the gate trench 290 may be formed such that one side surface in the first direction D1 is in contact with the first doping pillar 210, and the other side surface in the first direction D1 is in contact with the second doping pillar 230.

By the gate trench 290, the first conductivity type semiconductor layer 131, the first doping pillar 210, and the second doping pillar 230 may be exposed, and the side surfaces of the second conductivity type doped well region 133, the first conductivity type doped layer 137, and the second conductivity type doped layer 135 may be exposed.

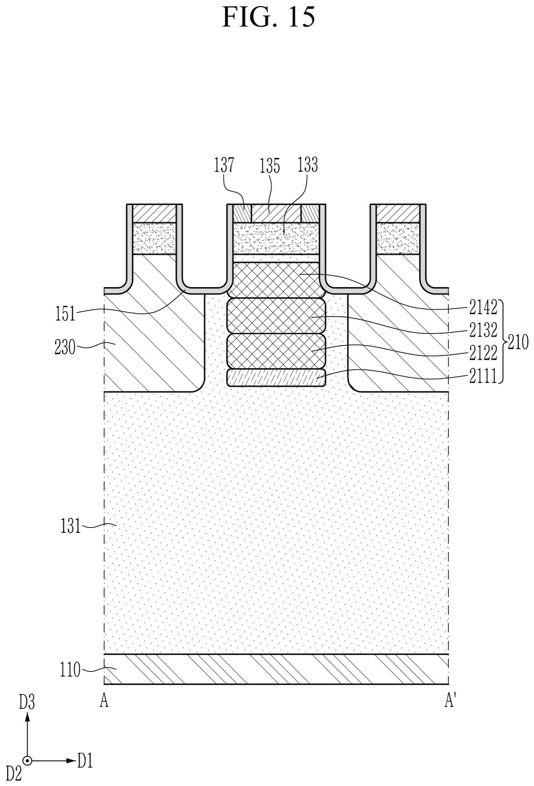

Referring to FIG. 15, the gate insulating layer 151 may be formed in the gate trench 290.

For example, the gate insulating layer 151 may be formed to conformally cover the inner surface of the gate trench 290. For example, the gate insulating layer 151 may be a thin film having a uniform thickness along the inner surface of the gate trench 290. The gate insulating layer 151 may be formed by a thermal oxidation method or a deposition method.

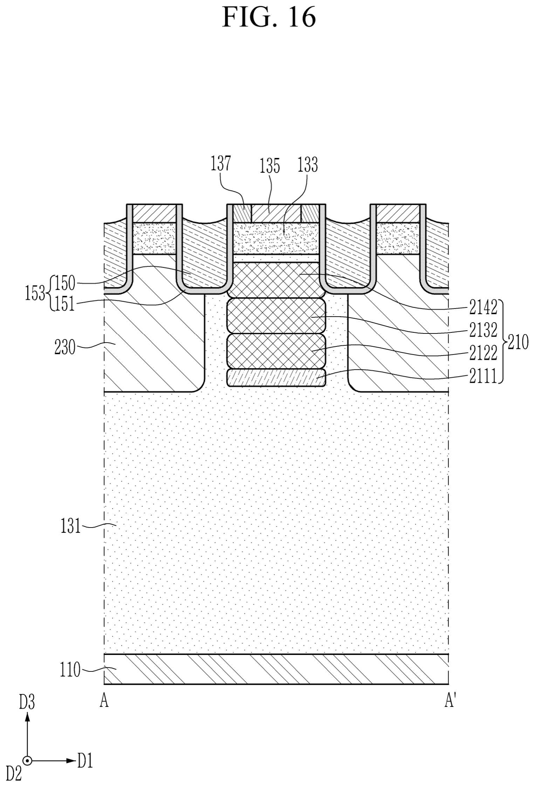

Referring to FIG. 16, the gate electrode 150 may be formed inside the gate trench 290. The gate electrode 150 and the gate insulating layer 151 may constitute the gate structure 153.

For example, the gate electrode 150 may be formed to fill the entire (or partial) internal space of the gate trench remaining after the gate insulating layer 151 is formed. In some embodiments, a portion of the gate electrode 150 may protrude over the gate trench 290, and a portion of the gate electrode 150 may also be positioned on the first conductivity type semiconductor layer 131. In addition, a portion of the gate electrode 150 may be formed on a portion of the field insulating layer. The gate electrode 150 may be formed by using a chemical vapor deposition (CVD) method, a photolithography method, or the like.

In some embodiments, after forming the gate insulating layer 151 and the gate electrode 150, the gate insulating layer 151 and the gate electrode 150 may be patterned to remove a portion of the gate insulating layer 151 and the gate electrode 150 positioned outside the gate trench 290. For example, the upper surface of the gate electrode 150 positioned inside the gate trench 290 may be partially recessed, such that a level in the third direction D3 of the upper surface of the gate electrode 150 may become lower than a level in the third direction D3 of the upper surface of the gate trench 290 or a level in the third direction D3 of the upper surface of the first conductivity type semiconductor layer 131. The remaining space inside the recessed gate trench 290 where the gate electrode 150 is positioned may be filled by the first interlayer insulating layer 140 thereafter. Patterning of the gate insulating layer 151 and the gate electrode 150 may, for example, utilize a photolithography method or a dry etching method.

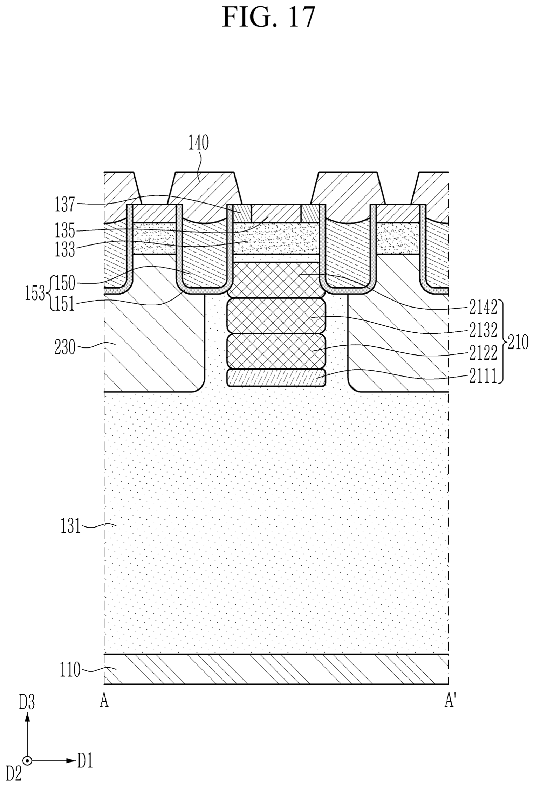

Referring to FIG. 17, the first interlayer insulating layer 140 may be formed on the second conductivity type doped well region 133.

The first interlayer insulating layer 140 may be formed to cover the gate structure 153, the first conductivity type semiconductor layer 131, the second conductivity type doped well region 133, the first conductivity type doped layer 137, and the second conductivity type doped layer 135. The first interlayer insulating layer 140 may be formed by a deposition method such as chemical vapor deposition (CVD).

Next, the first interlayer insulating layer 140 may be patterned so that a portion of the first interlayer insulating layer 140 may be removed.

For example, a portion of the first interlayer insulating layer 140 may be removed so as to expose a portion of an upper surface of the first conductivity type doped layer 137 and a portion of an upper surface of the second conductivity type doped layer 135. A region in which a portion of the first interlayer insulating layer 140 is removed may be a region where the source electrode 170 to be formed later. The removal of the first interlayer insulating layer 140 may be performed, for example, by using a photolithography method or a dry etching method.

In some embodiments, the silicide layer may be formed at a position where the first interlayer insulating layer 140 is removed. The silicide layer may be formed on the upper surface of the second conductivity type doped layer 135 exposed by removing a portion of the first interlayer insulating layer 140.

For example, a metal layer may be formed on the upper surface of the second conductivity type doped layer 135 by using a sputtering method or the like, and heat treatment may be performed at 600 °C to 1100 °C to react the metal and SiC to form a silicide.

In some embodiments, the metal layer remaining on the first interlayer insulating layer 140 after the silicide formation process may be removed by wet etching using sulfuric acid, nitric acid, hydrochloric acid, or a mixed solution of these and hydrogen peroxide.

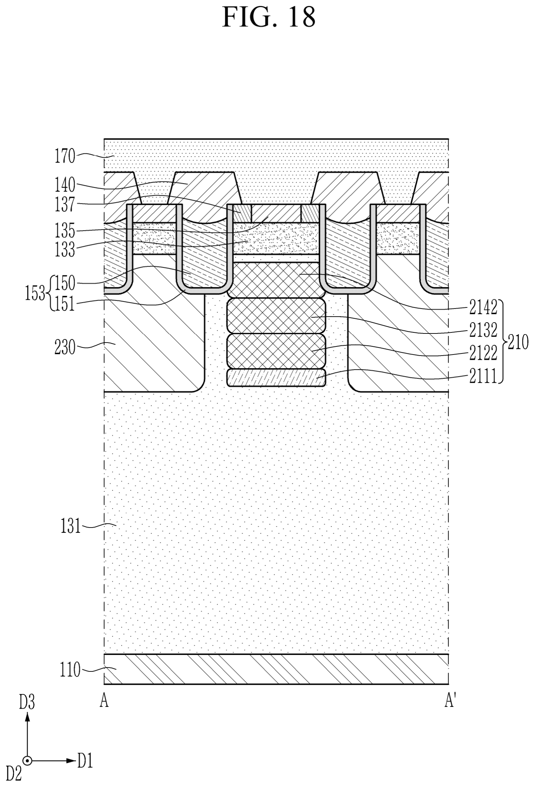

Referring to FIG. 18, the source electrode 170 may be formed on the first interlayer insulating layer 140.

For example, a conductive material may be deposited on the first interlayer insulating layer 140 and subjected to heat treatment to form the source electrode 170. The conductive material may be formed by a sputtering method, deposition method, or the like.

Referring again to FIG. 2, the drain electrode 180 may be formed on the second surface of the substrate 110.

For example, the process of forming the drain electrode 180 may include applying a conductive material on the entire second surface of the substrate 110, and performing heat treatment. The applying of the conductive material may be formed by a sputtering method or a deposition method. In some embodiments, the drain electrode 180 may be formed together with the source electrode 170 in the same process.

FIGS. 19 and 20 are graphs each illustrating a charge carrier dopant distribution. Referring to FIGS. 1 to 9, 19 and 20, according to some embodiments of the invention, a power semiconductor device may include a first conductivity type semiconductor layer 131 formed of a compound semiconductor material (e.g., SiC). The first conductivity type semiconductor layer 131 may have a first surface and a second surface facing away from each other in the third direction D3. A source electrode 170 may be disposed on the first surface of the first conductivity type semiconductor layer 131. A drain electrode 180 may be disposed on the second surface of the first conductivity type semiconductor layer 131. The drain electrode 180 may be electrically connected to the first conductivity type semiconductor layer 131. First conductivity type source regions 137 may be formed in the first conductivity type semiconductor layer 131 and electrically connected to the source electrode 170. Second conductivity type doped well regions 133 may be positioned in the first conductivity type semiconductor layer 131. The second conductivity type doped well regions 133 may be in contact with or directly adjacent to the first conductivity type source regions 137.

Gate electrodes 150 may be positioned between the second conductivity type doped well regions 133. The gate electrodes 150 may be configured to control current flow between the source electrode 170 and the drain electrode 180. The current may flow in a direction extending from the first surface of the first conductivity type semiconductor layer 131 to the second surface of the first conductivity type semiconductor layer 131. A gate insulating layer 151 may be positioned between the gate electrodes 150 and the second conductivity type doped well regions 133.

A plurality of sets of doped regions may be provided. The plurality of sets of doped regions may include a first set 210 of doped regions and a second set 230 of doped regions. For example, the first set 210 of doped regions and the second set 230 of doped regions may be a first doping pillar and a second doping pillar, respectively. The first set 210 of doped regions may be formed in the first conductivity type semiconductor layer 131. The first set 210 of doped regions may include doped regions 2111, 2122, 2131 and 2142. Each of the doped regions 2111, 2122, 2131 and 2142 of the first set 210 of doped regions may have the same conductivity type. For example, the doped regions 2111, 2122, 2131 and 2142 may have n-type. The doped regions 2111, 2122, 2131 and 2142 may be in contact with or directly adjacent to one another. In a plan view, a portion of the first set 210 of doped regions may be disposed between adjacent two of the gate electrodes 150.

FIG. 19 is a graph illustrating concentrations per unit volume of a first dopant and a second dopant in the doped regions 2111, 2122, 2131 and 2142. FIG. 20 is a graph illustrating a concentration per unit volume of a first conductivity-type dopant in the doped regions 2111, 2122, 2131 and 2142. For example, FIGS. 19 and 20 may illustrate concentrations measured along a first line (e.g., line B-B' shown in FIG. 2) extending from the source electrode to the drain electrode. The concentrations in the areas indicated by the reference numerals 2111, 2122, 2131 and 2142 in FIGS. 19 and 20 may correspond to those of the doped regions 2111, 2122, 2131 and 2142 in FIG. 2, respectively. For example, the first dopant may be nitrogen and the second dopant may be phosphorus as shown in FIG. 19, and FIG 20 may show a sum of the concentrations of the first dopant and the second dopant.

As shown in FIG. 20, a first charge carrier dopant concentration curve of the first set 210 of doped regions along the first line may have a first peak concentration PK11 and a second peak concentration PK12, PK13 or PK14. The peak concentrations PK11, PK12, PK13 and PK14 may correspond to the peak concentrations PK11, PK12, PK13 and PK14 shown in FIG. 19.

The first charge carrier dopant concentration curve may correspond to that of whichever is greater between p-type carriers and n-type carriers in each of the doped regions of the first set 210 of doped regions. A dominant atomic element (e.g., nitrogen) at the first peak concentration is different from a dominant atomic element (e.g., phosphorus) at the second peak concentration.

Each of the doped regions 2111, 2122, 2131 and 2142 may have a boundary corresponding to minima valleys of the first charge carrier concentration curve and/or points at which the charge carrier concentration is less than a predetermined concentration value PDV. For example, each of the boundaries may be a serial connection of a group of the first minima valleys and the points at which the charge carrier concentration is less than a predetermined concentration value PDV.

The dominant atomic element (e.g., nitrogen) at the first peak concentration may have smaller atomic mass than the dominant atomic element (e.g., phosphorus) at the second peak concentration. In the first charge carrier dopant concentration curve, the first peak concentration may be closer to the drain electrode than the second peak concentration is.

The power semiconductor device may further include the second set 230 of doped regions formed in the first conductivity type semiconductor layer 131. Though not shown in the drawings, the doped regions of the second set 230 of doped regions may be in contact with or directly adjacent to one another. In the plan view, a portion of the second set 230 of doped regions may be disposed between adjacent two of the gate electrodes 150. Each doped region of the second set 230 of doped regions may have the same conductivity type (e.g., p-type), which is different from the conductivity type (e.g., n-type) of each doped region of the first set 210 of doped regions.

Though not shown in the drawings, a second charge carrier dopant concentration curve of the second set 230 of doped regions (which is along a second line extending from the source electrode to the drain electrode) may have a third peak concentration and a fourth peak concentration. The second charge carrier dopant concentration curve of the second set 230 of doped regions may have a similar profile to that of the first charge carrier dopant concentration curve. The second charge carrier dopant concentration curve may correspond to that of whichever is greater between p-type carriers and n-type carriers in each of the doped regions of the second set 230 of doped regions. The second set 230 of doped regions may include a third doped region and a fourth doped region. A dominant atomic element (e.g., boron) at the third peak concentration is different from a dominant atomic element (e.g., aluminum) at the fourth peak concentration. The dominant atomic element (e.g., boron) in the third doped region of the second set 230 of doped regions may have smaller atomic mass than dominant atomic element (e.g., aluminum) in the third doped region of the second set 230 of doped regions. In the second charge carrier dopant concentration curve, the third peak concentration may be closer to the drain electrode than the fourth peak concentration is.

Although FIGS. 19 and 20 are described mainly in relation to the embodiment shown in FIG. 2, it will be readily understood by those skilled in the art that graphs similar to those of FIGS. 19 and 20 may likewise be derived from the descriptions of other embodiments (including the embodiments shown in FIGS. 3 to 9), and that the concentration profiles of such other embodiments can also be readily understood from the derived graphs.

The above detailed description of the embodiments of the present disclosure is not intended to limit the scope of the present invention. Rather, various modifications and improvements made by a person of ordinary skill in the art using the embodiments of the present disclosure without departing from the scope as defined in the appended claims.

Embodiments are set out in the following numbered clauses:
1. A semiconductor device comprising:
   a first conductivity type semiconductor layer;
   second conductivity type doped well regions positioned in the first conductivity type semiconductor layer and spaced apart from each other in a first direction;
   gate structures positioned on the first conductivity type semiconductor layer, wherein each of the gate structures includes a gate electrode positioned between adjacent well regions of the second conductivity type doped well regions and a gate insulating layer positioned between the first conductivity type semiconductor layer and the gate electrode;
   a doping pillar positioned below the second conductivity type doped well regions and within the first conductivity type semiconductor layer, wherein:
      a portion of the doping pillar is positioned between two of the gate structures in a plan view, and
      the doping pillar includes first dopants and second dopants that are different from each other; and
   a source electrode and a drain electrode positioned spaced apart from each other with one of the gate structures interposed therebetween.
2. The semiconductor device of clause 1, wherein:
   the portion of the doping pillar is positioned between the gate structures in the first direction,
   in the plan view, the doping pillar extends in a second direction different from the first direction, and
   the doping pillar is positioned below the second conductivity type doped well regions in a third direction different from the first direction and the second direction.
3. The semiconductor device of clause 2, wherein:
   the first dopants and the second dopants have the same conductivity type, and
   the doping pillar has a dopant configuration of either a first configuration or a second configuration,
   in the first configuration, the first dopants are nitrogen (N), and the second dopants are phosphorus (P) or arsenic (As), and
   in the second configuration, the first dopants are boron (B), and the second dopants are aluminum (Al) or gallium (Ga).
4. The semiconductor device of clause 3, wherein the doping pillar includes a first pillar region including more of the first dopants than the second dopants and a second pillar region including the second dopants more than the first dopants.
5. The semiconductor device of clause 3 or clause 4, wherein:
   the doping pillar consists of first pillar regions and second pillar regions stacked along the third direction,
   in each first pillar region, more of the first dopants are present than the second dopants, and
   in each second pillar region, the second dopants are more than the first dopants.
6. The semiconductor device of clause 5, wherein a length of each of the first pillar regions in the third direction is smaller than a length of each of the second pillar regions in the third direction.
7. The semiconductor device of any of clauses 5 to 6, wherein the first pillar regions are positioned closer to the drain electrode than the second pillar regions are.
8. The semiconductor device of any of clauses 5 to 7, wherein:
   the first pillar regions and the second pillar regions are alternately stacked, and
   one of the first pillar regions is positioned closer to the drain electrode than the second pillar regions are.
9. The semiconductor device of any of clauses 5 to 8, wherein:
   one of the first pillar regions is positioned closer to the source electrode than the second pillar regions are, and
   the second pillar regions are stacked between two of the first pillar regions.
10. The semiconductor device of any of clauses 5 to 9, wherein:
   one of the second pillar regions is positioned closer to the source electrode than the first pillar regions are,
   one of the second pillar regions is positioned closer to the drain electrode than the first pillar regions are, and
   the first pillar regions are stacked between two of the second pillar regions.
11. The semiconductor device of any of clauses 4 to 10, wherein the first pillar region is positioned within the second pillar region.
12. The semiconductor device of clause 2, wherein the doping pillar is connected to gate structures positioned adjacent to each other in the first direction.
13. The semiconductor device of any of clauses 2 to 12, wherein the first conductivity type semiconductor layer has a gate trench recessed toward the drain electrode, and a portion of the gate electrode is positioned within the gate trench.
14. The semiconductor device of any of clauses 1 to 13, wherein the semiconductor device further includes a second conductivity type shield region positioned in the first conductivity type semiconductor layer and adjacent below a lower surface of a corresponding one of the gate structures.
15. A semiconductor device comprising:
   a first conductivity type semiconductor layer;
   second conductivity type doped well regions positioned in the first conductivity type semiconductor layer and spaced apart from each other in a first direction;
   gate structures positioned on the first conductivity type semiconductor layer, wherein each of the gate structures includes a gate electrode positioned between adjacent well regions of the second conductivity type doped well regions and a gate insulating layer positioned between the first conductivity type semiconductor layer and the gate electrode;
   a doping pillar extending in a second direction that is different from the first direction, the doping pillar being positioned below the second conductivity type doped well regions and within the first conductivity type semiconductor layer, wherein a portion of the doping pillar is positioned between two of the gate structures; and
   a source electrode and a drain electrode positioned spaced apart from each other with one of the gate structures interposed therebetween,
   wherein, in a cross-section view along the first direction and the second direction, a side surface of the doping pillar has a plurality of convex portions protruding toward the first conductivity type semiconductor layer and concave portions indented with respect to the first conductivity type semiconductor layer along the second direction.
16. The semiconductor device of clause 15,
   wherein the doping pillar includes pillar regions each having one of the plurality of the convex portions, and
   wherein the pillar regions are stacked in the second direction, and wherein the concave portions are positioned at boundaries between the pillar regions.
17. The semiconductor device of clause 16,
   wherein the doping pillar includes a first pillar region having a first convex portion of the plurality of convex portions and a second pillar region having a second convex portion of the plurality of convex portions,
   wherein the doping pillar includes first dopants and second dopants, and the first dopants have the same conductivity type as the second dopants, and
   wherein the first pillar region includes more of the first dopants than the second dopants, and the second pillar region includes more of the second dopants than the first dopants.
18. A semiconductor device comprising:
   a first conductivity type semiconductor layer;
   second conductivity type doped well regions positioned in the first conductivity type semiconductor layer and spaced apart from each other in a horizontal direction;
   gate structures positioned on the first conductivity type semiconductor layer, wherein each of the gate structures includes a gate electrode positioned between adjacent will regions of the second conductivity type doped well regions and a gate insulating layer positioned between the first conductivity type semiconductor layer and the gate electrode;
   first doping pillars positioned below the second conductivity type doped well regions and within the first conductivity type semiconductor layer, wherein each of the first doping pillars includes different dopants of the same conductivity type, and a portion of each of the first doping pillars is positioned between adjacent gate structures of the gate structures;
   second doping pillars positioned below the second conductivity type doped well regions and within the first conductivity type semiconductor layer, wherein each of the second doping pillars has a different conductivity type from that of the first doping pillars; and
   a source electrode and a drain electrode spaced apart from each other with the gate structures interposed therebetween,
   wherein, within the first conductivity type semiconductor layer, the first doping pillars and the second doping pillars are alternatively arranged in the horizontal direction.
19. The semiconductor device of clause 18,
   wherein, in a plan view, a portion of each of the second doping pillars is positioned between two of the gate structures in the horizontal direction, and
   wherein each of the second doping pillars is in contact with two of the gate structures that are positioned adjacent to each other in the horizontal direction.
20. The semiconductor device of clause 19, wherein the gate structures are in contact with the second doping pillars, the first conductivity type semiconductor layer, and the first doping pillars.
21. A power semiconductor device comprising:
   a first conductivity type semiconductor layer formed of a compound semiconductor material, the first conductivity type semiconductor layer having a first surface and a second surface facing away from each other;
   a source electrode disposed on the first surface of the first conductivity type semiconductor layer;
   a drain electrode disposed on the second surface of the first conductivity type semiconductor layer, the drain electrode is electrically connected to the first conductivity type semiconductor layer;
   first conductivity type source regions formed in the first conductivity type semiconductor layer and electrically connected to the source electrode;
   second conductivity type doped well regions positioned in the first conductivity type semiconductor layer, the second conductivity type doped well regions being in contact with the first conductivity type source regions;
   gate electrodes positioned between the second conductivity type doped well regions, the gate electrodes being configured to control current flow:
      between the source electrode and the drain electrode, and
      in a direction extending from the first surface of the first conductivity type semiconductor layer to the second surface of the first conductivity type semiconductor layer;
   a gate insulating layer positioned between the gate electrodes and the second conductivity type doped well regions; and
   a first set of doped regions formed in the first conductivity type semiconductor layer,
   wherein:
      each doped region of the first set of doped regions has the same conductivity type,
      the doped regions of the first set of doped regions are in contact with one another,
      a first charge carrier dopant concentration curve of the first set of doped regions along a first line extending from the source electrode to the drain electrode has a first peak concentration and a second peak concentration,
      the first charge carrier dopant concentration curve corresponds to that of whichever is greater between p-type carriers and n-type carriers in each doped region of the first set of doped regions,
      a dominant atomic element at the first peak concentration is different from that at the second peak concentration, and
      in a plan view, a portion of the first set of doped regions is disposed between adjacent two of the gate electrodes.
22. The power semiconductor device of clause 21, wherein:
   the dominant atomic element at the first peak concentration has smaller atomic mass than that at the second peak concentration, and
   in the first charge carrier dopant concentration curve, the first peak concentration is closer to the drain electrode than the second peak concentration is.
23. The power semiconductor device of clause 21 or 22, further comprising:
   a second set of doped regions formed in the first conductivity type semiconductor layer,
   wherein:
      each doped region of the second set of doped regions has the same conductivity type, which is different from those of each doped region of the first set of doped regions,
      the doped regions of the second set of doped regions are in contact with one another,
      a second charge carrier dopant concentration curve of the second set of doped regions along a second line extending from the source electrode to the drain electrode has a third peak concentration and a fourth peak concentration,
      the second charge carrier dopant concentration curve corresponds to that of whichever is greater between p-type carriers and n-type carriers in each doped region of the second set of doped regions,
      the second set of doped regions includes a third doped region and a fourth doped region,
      a dominant atomic element at the third peak concentration is different from that at the fourth peak concentration,
      in the plan view, a portion of the second set of doped regions is disposed between adjacent two of the gate electrodes,
      the dominant atomic element in the third doped region of the second set of doped regions has smaller atomic mass than that in the third doped region of the second set of doped regions, and
      in the second charge carrier dopant concentration curve, the third peak concentration is closer to the drain electrode than the fourth peak concentration is.

## Claims

1. A semiconductor device comprising:
a first conductivity type semiconductor layer;
second conductivity type doped well regions positioned in the first conductivity type semiconductor layer and spaced apart from each other in a first direction;
gate structures positioned on the first conductivity type semiconductor layer, wherein each of the gate structures includes a gate electrode positioned between adjacent well regions of the second conductivity type doped well regions and a gate insulating layer positioned between the first conductivity type semiconductor layer and the gate electrode;
a doping pillar positioned below the second conductivity type doped well regions and within the first conductivity type semiconductor layer, wherein:
a portion of the doping pillar is positioned between two of the gate structures in a plan view, and
the doping pillar includes first dopants and second dopants that are different from each other; and
a source electrode and a drain electrode positioned spaced apart from each other with one of the gate structures interposed therebetween.

2. The semiconductor device of claim 1, wherein:
the portion of the doping pillar is positioned between the gate structures in the first direction,
in the plan view, the doping pillar extends in a second direction different from the first direction, and
the doping pillar is positioned below the second conductivity type doped well regions in a third direction different from the first direction and the second direction.

3. The semiconductor device of claim 2, wherein:
the first dopants and the second dopants have the same conductivity type, and
the doping pillar has a dopant configuration of either a first configuration or a second configuration,
in the first configuration, the first dopants are nitrogen (N), and the second dopants are phosphorus (P) or arsenic (As), and
in the second configuration, the first dopants are boron (B), and the second dopants are aluminum (Al) or gallium (Ga).

4. The semiconductor device of claim 3, wherein the doping pillar includes a first pillar region including more of the first dopants than the second dopants and a second pillar region including the second dopants more than the first dopants.

5. The semiconductor device of claim 3 or claim 4, wherein:
the doping pillar consists of first pillar regions and second pillar regions stacked along the third direction,
in each first pillar region, more of the first dopants are present than the second dopants, and
in each second pillar region, the second dopants are more than the first dopants.

6. The semiconductor device of claim 5, wherein a length of each of the first pillar regions in the third direction is smaller than a length of each of the second pillar regions in the third direction.

7. The semiconductor device of claim 5 or claim 6, wherein the first pillar regions are positioned closer to the drain electrode than the second pillar regions are.

8. The semiconductor device of any of claims 5 to 7, wherein:
the first pillar regions and the second pillar regions are alternately stacked, and
one of the first pillar regions is positioned closer to the drain electrode than the second pillar regions are.

9. The semiconductor device of any of claims 5 to 8, wherein:
one of the first pillar regions is positioned closer to the source electrode than the second pillar regions are, and
the second pillar regions are stacked between two of the first pillar regions.

10. The semiconductor device of any of claims 5 to 9, wherein:
one of the second pillar regions is positioned closer to the source electrode than the first pillar regions are,
one of the second pillar regions is positioned closer to the drain electrode than the first pillar regions are, and
the first pillar regions are stacked between two of the second pillar regions.

11. The semiconductor device of any of claims 4 to 10, wherein the first pillar region is positioned within the second pillar region.

12. The semiconductor device of any of claims 2 to 11, wherein the doping pillar is connected to gate structures positioned adjacent to each other in the first direction.

13. The semiconductor device of any of claims 2 to 12, wherein the first conductivity type semiconductor layer has a gate trench recessed toward the drain electrode, and a portion of the gate electrode is positioned within the gate trench.

14. The semiconductor device of any preceding claim, wherein the semiconductor device further includes a second conductivity type shield region positioned in the first conductivity type semiconductor layer and adjacent below a lower surface of a corresponding one of the gate structures.

15. The semiconductor device of any preceding claim,
wherein, in a cross-section view along the first direction and the second direction, a side surface of the doping pillar has a plurality of convex portions protruding toward the first conductivity type semiconductor layer and concave portions indented with respect to the first conductivity type semiconductor layer along the second direction.
